# EUROPEAN PATENT APPLICATION

(11) **EP 2 388 687 A2**
(43) Date of publication of application: **23.11.2011**
(21) Application number: 10731415.5
(22) Date of filing: 18.01.2010
(51) Int. Cl.: G06F 3/14, G06F 1/16, G02F 1/13

(54) **PORTABLE DISPLAY DEVICE**

(30) Priority: 19.01.2009 KR 20090004256
(71) Applicant: Kim, Si Hwan, Kyunggi-Do 464-862 (KR)
(72) Inventor: Kim, Si Hwan, Kyunggi-Do 464-862 (KR)
(74) Representative: Tersteegen, Felix
(86) International application number: PCT/KR2010/000312
(87) International publication number: WO 2010/082800

(57) **Abstract**

A method of using two display panels as a single screen is provided. More particularly, a structure for minimizing the size of a joint between two display panels and an algorithm for coping with a situation where a text line or a text image is located at the joint are provided. A portable display device has at least two panel housings and first and second display panels mounted on the panel housings, respectively, in which the display panels are joined to each other to form a single screen when the panel housings are unfolded. When a text line or a text image is located at the joint between the first and second display panels, a screen is shifted so that the joint is located in a space between the text lines.

## Description

### Technical Field

The present invention relates to a method of using two display panels as a single screen, and more particularly, to a structure for minimizing the size of a joint between two display panels and an algorithm for coping with a situation where a text line or a text image is located at the joint.

### Background Art

In order to enlarge a screen of a portable display device, two display panels are joined to each other to form a single screen. Various flat display panels such as an LCD, an OLED, an FED, a PDP, and an electronic paper can be used for this purpose.

The portable display device includes plural panel housings that can be folded and unfolded and plural display panels mounted on the panel housings, respectively, and has a structure in which the display panels are contiguous to each other when the display panels are unfolded.

However, since two display panels are used, a non-display area cannot help existing therebetween. The non-display area results from a boundary, the thickness of a protective plate a protective member, the thickness of the panel housings, and the width of a joint between the display panels.

When a text line or a text image is located in the non-display area, it is difficult to read the text line or the text image due to the boundary. A specific solution to this problem is not proposed yet.

### Disclosure of the Invention

### Technical Goal

A goal of the invention is to provide a structure and an algorithm for coping with a problem in that it is difficult to read a text line or a text image when the text line or the text image is located at a joint, that is, a boundary, between two display panels, when panel housings are unfolded and two display panels are joined to each other to form a single screen.

### Technical Solution

According to an aspect of the invention, there is provided a portable display device having at least two panel housings and first and second display panels mounted on the panel housings, respectively, in which the display panels are joined to each other to form a single screen when the panel housings are unfolded. Here, the first and second display panels display a single picture vertically or horizontally divided into two parts and the first and second display panels are configured to be contiguous to each other. A first input device corresponding to output information to the first display panel and a second input device corresponding to output information to the second display panel are provided to the portable display device. The first and second input devices are contiguous to each other to serve as a single input device.

In the portable display device, a gravity sensor may be disposed in each of the panel housings, and a central processing unit may select one of an operation of vertically dividing a picture to be displayed and an operation of horizontally dividing the picture depending on the output of the gravity sensors.

In the portable display device, the distance between the first and second display panels may be in the range of 0.01 mm to 5 mm and the distance between the first and second input devices may be in the range of 0.01 mm to 4 mm.

In the portable display device, optical members may be disposed on the display panels, respectively, and the distance between the optical members may be in the range of 0.01 mm to 3 mm.

In the portable display device, when a text line is located at a boundary between the first and second display panels, the screen may be shifted so that the boundary between the first and second display panels is located in a space between the text lines.

### Advantageous Effects

According to the invention, when the panel housings are unfolded, two display panels are joined to each other to form a single screen. At this time, a boundary is formed by the joint between two display panels. When a text line or a text image is located at the boundary to deteriorate the visibility, the screen can be automatically shifted so that the text line or the text image is not located at the boundary. Accordingly, a user can read the text without any trouble, even when a text line or a text image is located at the boundary.

### Brief Description of the Drawings

Figs. 1 and 2 are diagrams illustrating a foldable type portable display device according to an embodiment of the invention.
Figs. 3 to 5 are sectional views illustrating a state where panel housings are unfolded.
Figs. 6 to 8 are sectional views illustrating a state where the panel housings are unfolded according to another embodiment of the invention.
Fig. 9 is a diagram illustrating a boundary in detail.
Fig. 10 is a block diagram illustrating the configuration of a display device according to an embodiment of the invention, where display panels are driven.
Figs. 11 to 14 are block diagrams according to an embodiment of the invention.
Fig. 15 is a flowchart according to an embodiment of the invention.
Figs. 16 and 17 are diagrams illustrating a driving method according to an embodiment of the invention.
Figs. 18 and 19 are diagrams illustrating a screen pattern.
Figs. 20 to 24 are flowcharts illustrating an algorithm for preventing a text line from being located at the boundary between display panels.
Fig. 25 is a diagram illustrating an example where the distance between the display panels is equal to the distance between the input devices.
Fig. 26 is a diagram illustrating an example where the distance between the input devices is smaller than the distance between the display panels.
Figs. 27 to 29 are diagrams illustrating an example where an optical member is provided.
Figs. 30 and 31 is a diagram illustrating an example of the arrangement of the display panels and components.
Figs. 32 and 33 are diagrams an example where an input device is mounted on a display panel.
Figs. 34 to 36 are diagrams illustrating the details of the display panel and the input device.
Figs. 37 and 38 are diagrams illustrating a state where the display panel mounted with the input device is mounted on the panel housing.
Fig. 39 is a perspective view of the panel housing mounted with the display panel.
Fig. 40 is a diagram illustrating an example where the display panel and the input device are individually mounted on the panel housing.
Figs. 41 to 44 are diagrams illustrating another example where the display panel and the input device are individually mounted on the panel housing.
Fig. 45 is a diagram illustrating the actual arrangement of the display panels and the input devices.
Fig. 46 is a diagram illustrating the structure of an electrode in the display panel.
Figs. 47 to 49 are diagrams illustrating the shape of another example of the display panels.
Figs. 50 to 53 are diagrams illustrating another example where the display panels are mounted on the panel housings.
Fig. 54 is a diagram illustrating an example where a lid is mounted on the input device.
Figs. 55 and 56 are diagrams illustrating another example where an input device is provided.
Figs. 57 to 59 are diagrams illustrating examples of the input device.
Figs. 60 to 65 are diagrams illustrating a pattern of a functional plate and lead lines.
Figs. 66 to 68 are diagrams illustrating an example where the input device and the optical member are both mounted on the display panel.
Figs. 69 and 70 are diagrams illustrating an example where the optical member is provided as the uppermost.
Figs. 71 to 76 are diagrams illustrating an example where the invention employs a sliding structure
Figs. 77 to 82 are diagrams illustrating an example where the invention employs another structure.
Figs. 83 to 87 are diagrams illustrating an example where the invention is applied to a coupling type display device.
Figs. 88 to 90 are diagrams illustrating examples where the portable display device according to the invention can be controlled in a wired or wireless manner.

### Detailed Descriptions of the Invention

Hereinafter, exemplary embodiments of the invention will be described with reference to the accompanying drawings.

The invention provides an algorithm of shifting a screen vertically or horizontally so as not to locate a text or a text image at a boundary when the text or the text image is located at the boundary in a foldable type portable display device in which at least two flat display panels are joined to each other to form a signal screen.

In the invention, text means letters and more clearly a text line. The text image means a text image file representing an image, not a text file.

All flat display panels such as an LCD, an FED, a PDP, and an electronic paper can be used as the flat display panels in the invention.

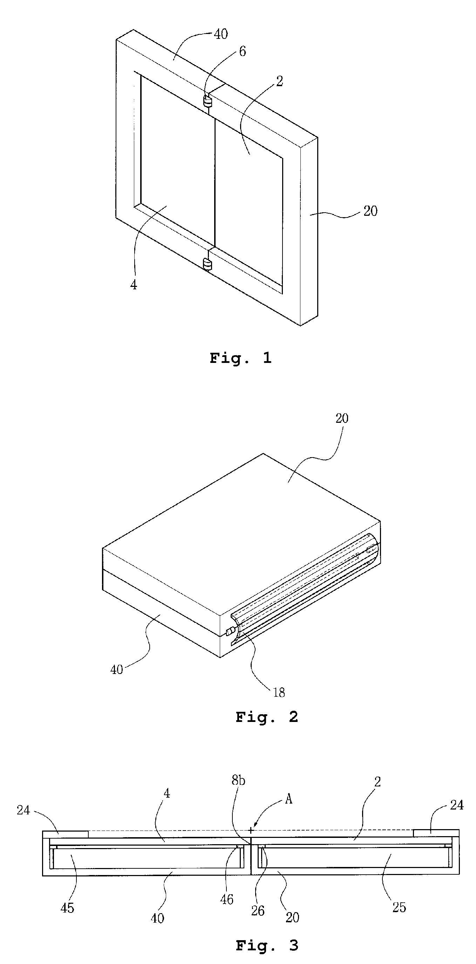

Figs. 1 and 2 are diagrams illustrating a foldable type portable display device according to the invention.

As shown in Fig. 1, the foldable type portable display device according to the invention includes two display panels 2 and 4 and two panel housings 20 and 40 mounted with the display panels, respectively. The panels housings 20 and 40 include circuits and components used to drive or mount the display panels.

The two panel housings 20 and 40 are joined by a joint member 6 that can be folded and unfolded. A hinge is used as the joint member 6 in this example. However, in the foldable type display device according to the invention, the joint member is not limited to the hinge, as long as it can allow to the panels housings to be folded and unfolded.

That is, the joint member is not limited to the hinge or shaft type, as long as it can join the two panel housings so as to be folded and unfolded.

Fig. 2 is a diagram illustrating a state where the foldable type portable display device according to the invention is folded.

A cover member 18 is disposed on the side surfaces of the panel housings 20 and 40. The cover member protects the side surfaces of the display panels when the display panels 2 and 4 are folded.

The invention is not limited to the shape of the cover member shown in Fig. 2, as long as it can cover the sides surfaces when the panel housings are folded.

Figs. 3 to 5 are sectional views illustrating a state where the panel housings are unfolded.

Fig. 3 is a diagram illustrating a state where the display panels 2 and 4 are mounted on the panel housings 20 and 40, respectively. As shown in the drawing, when the panel housings 20 and 40 are unfolded and are joined to each other, the display panels 2 and 4 are contiguous to each other.

At this time, when the panel housings 20 and 40 are unfolded, the display panels 2 and 4 are located on the sides walls of the panel housings 20 and 40 which come in close contact with each other so as to cause the display panels 2 and 4 to be contiguous to each other.

Various circuits and devices 25 and 45 are disposed in the panel housings 20 and 40 and supports 26 and 46 supporting the display panels 2 and 4 are also disposed. Lids 24 are disposed at the edges of the display panels 2 and 4, respectively. On the other hand, the cover member 18 is not shown for the purpose of easy explanation. The extension line of the rotation center A is flush with the surfaces of the lids 24. That is, the level of the rotation center is equal to the level of the lids.

When the display panels 2 and 4 are joined to each other, the distance between the display panels is about 0.01 mm.

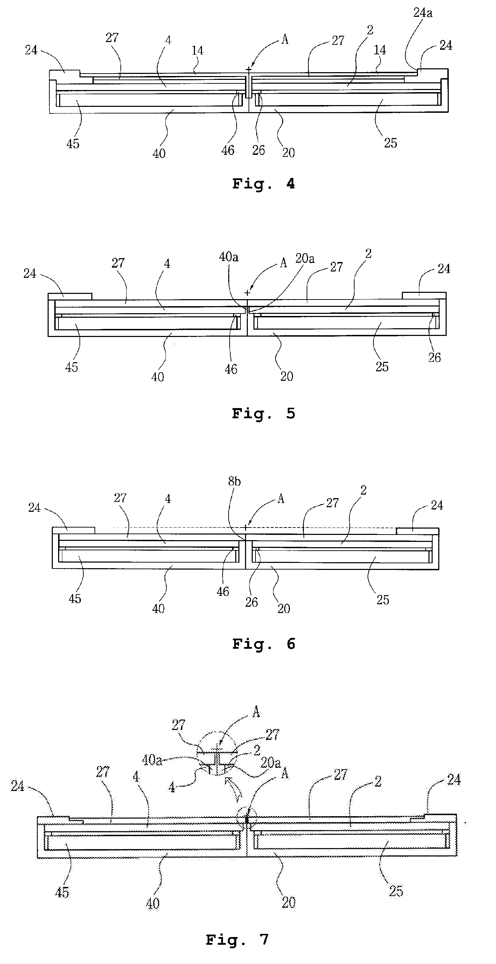

Fig. 4 is a diagram illustrating an example where a protective member is disposed on the display panels. As shown in the drawing, when a stepped portion 24a is disposed in the side surface of each lid 24 and the protective member 14 is disposed in the stepped portion 24a, the protective member 14 can be mounted on the sides surfaces of the display panels 2 and 4 and the front surfaces of the display panels 2 and 4.

An optical member 27 may be disposed under the protective member 14. The optical member is a member used to optically reduce a joint which is a boundary between the display panels 2 and 4. The protective member 14 has a thickness of 1 mm or 0.5 mm or less.

Fig. 5 is a diagram illustrating an example where a joint portion is disposed on the side surfaces of the panel housings. When the panel housings 20 and 40 are unfolded, the display panels 2 and 4 are contiguous to each other and joint portions 20a and 40a are disposed therebetween. That is, the contact side surfaces of the panel housings 20 and 40 are cut out to form the joint 8b or the joint portions 20a and 40a, whereby the display panels 2 and 4 are contiguous to each other.

The joint portions 20a and 40a may be formed thinner than the other portions of the panel housings 20 and 40, for example, with a thickness of 0.5 mm or less.

Figs. 6 to 8 are diagrams illustrating sectional views illustrating other examples where the panel housings are unfolded.

Fig. 6 is a diagram illustrating an example where an optical member is disposed on the display panels. As shown in the drawing, when the panel housings 20 and 40 are unfolded and are joined to each other, the optical member 27 is contiguous to each other.

When the panel housings 20 and 40 are unfolded, optical members 27 are disposed on the joint 8b of the panel housings 20 and 40 so as to cause the optical members 27 to be contiguous to each other.

As shown in the drawing, the display panels 2 and 4 are disposed adjacent to the joint 8b of the panel housings 20 and 40. The width of the joint 8b of the panel housings 20 and 40 is preferably about 1 mm, and may be 2.5 mm for the purpose of enhancement in reliability. Therefore, the maximum distance between the display panels 2 and 4 is 5 mm.

On the contrary, the width of the joint is 1 mm but the distance between the display panels 2 and 4 and the joint may be set to 1.5 mm. In this case, the maximum distance between the display panels 2 and 4 is 5 mm.

Fig. 7 is a diagram illustrating an example where the joint portions are disposed on the sidewalls of the panel housings. When the panel housings 20 and 40 are unfolded, the optical members 27 are contiguous to each other and the joint portions 20a and 40a are disposed therebetween. That is, the side surfaces of the panel housings 20 and 40 are cut out to form the joint portions 20a and 40a, whereby the optical members 27 are contiguous to each other.

The joint portions 20a and 40a may be formed thinner than the other portions of the panel housings 20 and 40, or a thickness of 0.3 mm to 0.5 mm.

That is, in the example shown in Fig. 6, when the panel housings 20 and 40 are unfolded, the optical members 27 are joined to each other. At this time, the minimum distance therebetween may be said to be 0 mm, but the minimum distance of about 0.01 mm is actually present therebetween.

The thickness of the panel housings 20 and 40 shown in Fig. 6 is normally 1 mm and the maximum thickness thereof may be 2.5 mm. Accordingly, the width of the joint portions 20a and 40a between the optical members 27 is normally 0.5 mm and the maximum width may be about 1.5 mm. Therefore, when the panel housings are unfolded, the distance between the optical members is normally 1 mm and the maximum distance may be about 3 mm.

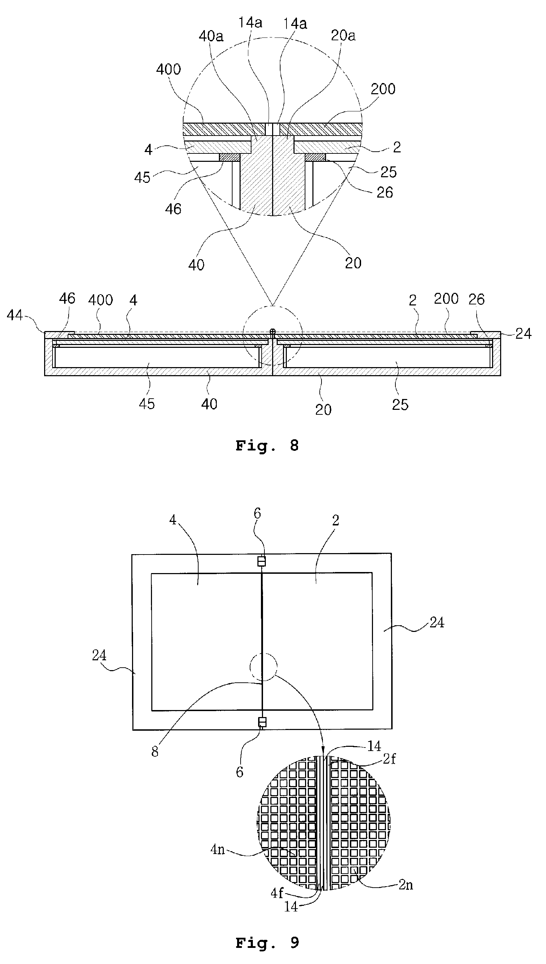

Fig. 8 is a diagram illustrating an example where input devices 200 and 400 are disposed on the display panels 2 and 4. As shown in the drawing, the input devices 200 and 400 are disposed on the display panels 2 and 4 and a protective member 14a such as a protective film or a protective plate is additionally disposed in close contact with the input devices 200 and 400. That is, the distance between the input devices 200 and 400 is smaller than the distance between the display panels 2 and 4.

At this time, the maximum distance between the display panels 2 and 4 is in the range of 2 mm to 3 mm. However, the input devices are located in the space between the display panels and thus the distance between the input devices 200 and 400 is smaller than 3 mm and more preferably smaller than 3 mm.

When the maximum distance between the display panels 2 and 4 are set to 5 mm, the maximum distance between the input devices 200 and 400 may be set to about 4 mm.

Fig. 9 is a diagram illustrating the boundary in detail.

The boundary as the joint of the display panels is shown in detail in the circle.

The joint 8 as the boundary forms a non-display area in which the screens of the display panels 2 and 4 are not displayed. As shown in Fig. 9, the non-display area includes the sidewalls of the panel housings 20 and 40, the protective films 14, 160, and 16, and the sealants 2f and 4f. In the drawing, the non-display area is referenced by B and the total non-display area is double of B.

That is, when a text line or a text image is located in the boundary, the screen should be shifted due to the non-display area. When the text line is located in the non-display area, the letters (the text line or the text image) are poor in visibility. Therefore, the screen should be shifted so that the non-display area is located between the text lines.

Here, the protective film 14 may be a protective member 14 protecting the side surfaces of the optical members or may be a structure of a chassis constituting the side surface of the joint of the display panels 2 and 4. The protective film normally has a thickness of 0.5 mm or less and the total thickness is about 1 mm or less.

The non-display area includes the space between the pixels and the display boundary and the width thereof is as follows.

The sealant normally has a thickness of 0.8 mm or less and more preferably a thickness of 0.3 mm to 0.5 mm.

The pixels 2n and 4n of the display panels located adjacent to the joint 8 are present. The distance between the pixels adjacent to the sealant 2f and the sealant is in the range of 0.1 to 0.2 mm. Accordingly, the distance between the display boundary to the pixels is equal to or less than 1.0 mm. Wherefore, when the first display panel 2 and the second display panel 4 come in contact with each other, the total distance is 2 mm.

When the maximum distance between the display panels, which is described with reference to Figs. 6 to 8, is 5 mm, the maximum width of the non-display area is 8 mm by adding the thickness 1 mm of the chassis or structure and the distance 2 mm from the pixels (double the distance 1 mm between the display boundary to the pixels) thereto.

When the distance between the display panels is 3 mm, the thickness of the chassis or structure is minimized, and the distance between the display boundary and the pixel is optimized, the width of the non-display area may be set to be 5 mm or 6 mm or less.

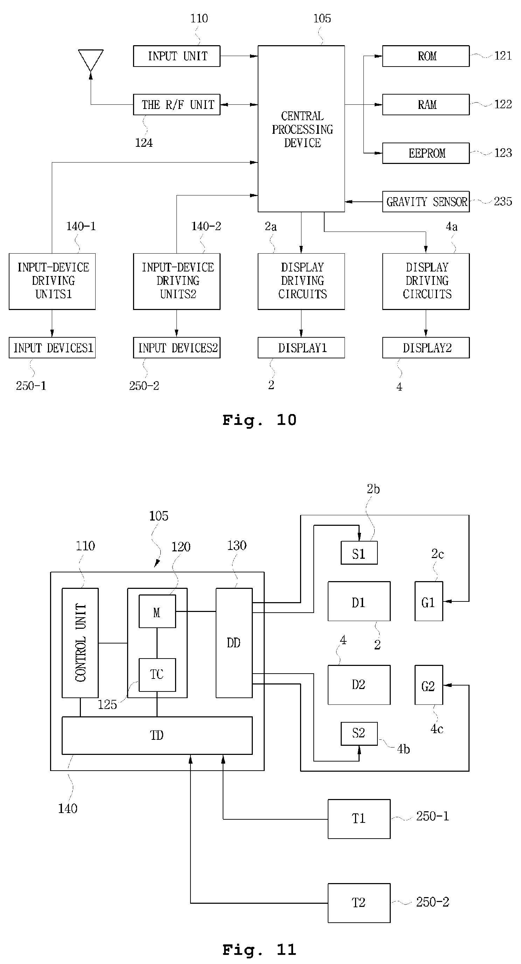

Fig. 10 is a block diagram illustrating the driving operation of the display device according to the invention.

In the drawing, a central processing device 105 is a control unit that controls the overall operation of the portable display device according to the invention. A ROM 121 controls programs executed by the display device, a RAM 122 stores data generated at the time of executing the programs, and an EEPROM 123 stores data necessary for a user or data necessary for processing the data.

The R/F unit 124 tunes an RF channel as a radio frequency, amplifies an input sound signal, and converts an RF signal received via an antenna into an intermediate frequency signal. An input unit 110 includes various input devices, ten keys, a menu key, and a selection key.

Display driving circuits 2a and 4a serve to drive the display panels on the basis of the output of the central processing unit 105. The first and second display panels 2 and 4 display information on the screens on the basis of the output signal of the driving circuits.

The display device further includes a gravity sensor 235 that determines whether two display panels 2 and 4 are located vertically or horizontally. That is, the central processing unit 105 determines whether two display panels 2 and 4 are arranged vertically or horizontally on the basis of the input signal from the gravity sensor 235. This determination is performed on the basis of the output of the gravity sensor by the use of a predetermined program.

To determine whether the screens of the display panels are arranged vertically or horizontally, the gravity sensor senses the rotation of 90 degrees. When the output of the gravity sensor is changed, the screen of the display device is rotated by 90 degrees in response to the output.

In a normal gravity sensor, a weight is connected to a variable resistor and the present posture of the display device is acquired by the variation in resistance resulting from the rotation.

A gravity sensor including a rotating plate and a weight may be used. A signal code and a measurement signal detected in a contact (or non-contact) manner are acquired with the rotation of the weight. This gravity sensor is widely known in the art. Other gravity sensors may be used.

The portable display device has a rectangular shape or a square shape and thus the screen is preferably changed when the display device is normally by about 90 degrees. Accordingly, the gravity sensor 235 is designed preferably to sense the rotation of 90 degrees. In the invention, it is assumed that the state where the display panels 2 and 4 are arranged vertically is determined as a normal state and the state where the display panels 2 and 4 are arranged horizontally is determined as an abnormal state.

The screen may be shifted manually through the use of the input device or the menu button. That is, when a manual change mode is set for the screen, the screen is not shifted in spite of the output of the gravity sensor.

The central processing unit controls the first and second input devices 250-1 and 250-2 through the use of first and second input-device driving units 140-1 and 140-2. That is, since two input devices 250-1 and 250-2 are present, two input-device driving units 140-1 and 140-2 are present to control the corresponding input devices.

The input devices 250-1 and 250-2 shown in Fig. 10 are the same as the input devices 200 and 400 shown in the other drawings of the invention.

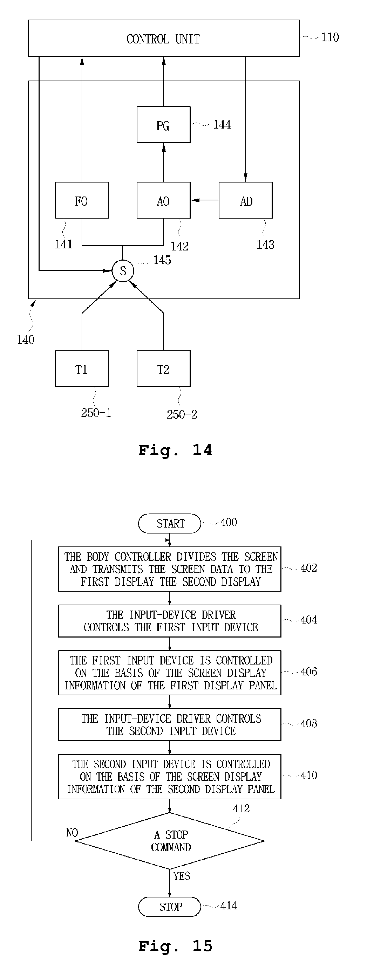

Figs. 11 to 14 are block diagrams illustrating the invention and Fig. 15 is a flowchart illustrating the control process in the invention.

In the invention, two display panels 2 and 4 and two input devices 250-1 and 250-2 are provided, and the input devices are mounted on the display panels.

Accordingly, in the invention, the control unit controlling two display panels 2 and 4 also controls the signals output from two input devices 250-1 and 250-2.

As shown in Fig. 11, the central processing unit or a body controller 105 includes a control unit 110, a memory 120, a time controller 125, a display driver 130, and an input-device driver 140.

That is, the units serving as the control unit 110, the memory 120, the time controller 125, the display driver 130, and the input-device driver 140 can be included in the body controller 105 and can be manufactured as a single module.

The display driver 130 divides the screen and supplies data to the first display panel 2 and the second display panel 4. The input-device driver 140 corrects and adjusts signals output from the first input device 250-1 and the second input device 250-2.

Source units 2b and 4b supplying data signals and gate units 2c and 4c supplying line selection signals are provided to display the screens of the display panels 2 and 4.

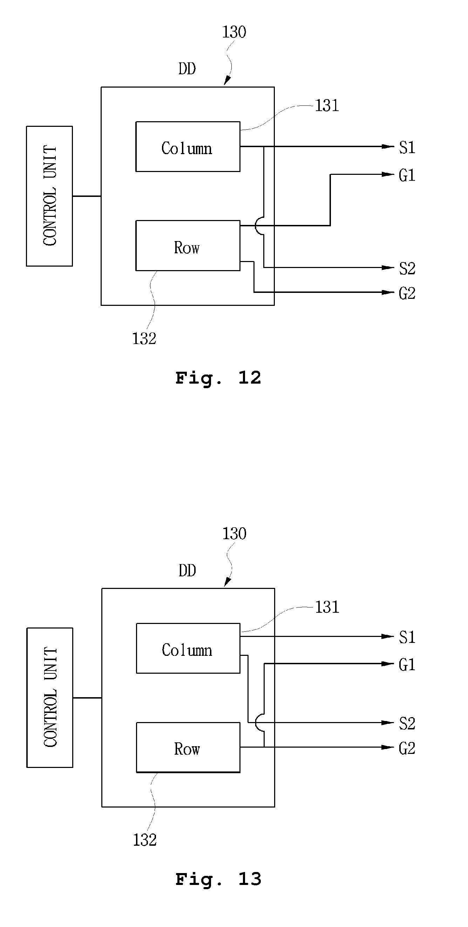

Figs. 12 and 13 show the display driver 130. The display driver 130 includes a column data processor 131 and a row data processor 132.

A method of dividing a signal display screen into two screens can be classified into a method of dividing the source data and a method of dividing the gate signals.

As shown in Fig. 12, the column data processor 131 supplying the source data (data signals of the screen) supplies the same data signals to the first display panel 2 and the second display panel 4, and the row data processor 132 divides a signal (gate signals) and supplies the divided signals to the first display panel 2 and the second display panel 4.

For example, when the total number of pixels of the screen is 320x240 dots, the number of data lines (source lines, column lines) is 320 and the number of selection signal lines (gate lines, row lines) is 240.

In this case, each of the first display panel 2 and the second display panel includes 320 data lines and 120 selection signal lines. That is, the data lines are not divided but the selection signal lines (gate lines) are divided.

The ratio of division is normally 1:1 (240 lines of the total screen are divided into 120 lines and 120 lines) and the ratio can be adjusted depending on the design of the display device. For example, the ratio of division may be adjusted so that the first display panel includes 140 lines and the second display panel includes 100 lines.

Since the selection signal lines sequentially supply the selection signals with the same repeated waveforms, the selection signal lines are simply divided but supply the same signal under the control of the time controller 125.

As shown in the block diagram of Fig. 13, the row data processor 132 supplying the gate signals supplies the same data signals to the first display panel 2 and the second display panel 4, and the column data processor 131 supplying the source data (data signals) divides the signals and supplies the divided signals to the first display panel 2 and the second display panel 4.

That is, when the number of pixels is 320x240 dots as described with reference to Fig. 12, each of the first display panel 2 and the second display panel 4 includes 240 gate lines and each of the first display panel 2 and the second display panel 4 includes 160 source lines.

That is, when the number of data lines is 320 in the entire screen before the division, the first to 160-th lines supply the signals to the first display panel 2 and the 161-th to 320-th lines supply the signals to the second display panel 4. The entire screen data information before the division stored in the memory 120 is divided by the control unit 110 and the time controller 125.

The data lines of the first display panel 2 and the data lines of the second display panel 4 do not have to be divided in 1:1. The data lines may be divided at various ratios such as 2:3, 10:6, and 6:4. That is, the first display panel 2 and the second display panel 4 do not have to have the capacity of 1:1 and may be set to various ratios depending on the design of the display device.

Fig. 14 is a diagram illustrating the detailed configuration of the input-device driver 140.

A calibration function executing unit 141 executes a function of calibrating the input devices 250 at the time of starting up the system. A panel signal corresponding to correct coordinate values in the input devices 250 is selected by the calibration function executed by the calibration function executing unit 141.

That is, the signal in the input devices 250 corresponding to the coordinate values depending on the resolution (the numbers of source and gate lines) of the display panels 2 and 4 is selected and the selected signal is supplied to the control unit 110. Accordingly, the control unit 110 stores and manages the coordinate values corresponding to the panel signals.

An average detection number adjusting unit 143 adjusts the number of times of detecting an average value for the panel signal output from the input device 250 on the basis of the screen resolution information of the display devices 2 and 4 supplied from the control unit 110. When the screen resolution is changed to a high resolution, the number of times of detecting an average value is adjusted to be greater than the previously set value. On the contrary, when the screen resolution is changed to a low resolution, the number of times of detecting an average value is adjusted to be smaller than the previously set value.

An average value detector 142 detects the average value of the panel signal transmitted from the input devices 250 on the basis of the number of times of detecting an average value, which is adjusted by the average detection number adjusting unit 143. The detected average value is transmitted to a panel signal generator 144.

The panel signal generator 144 generates an adjusted panel signal on the basis of the changed screen resolution of the display panels 2 and 4 supplied from the control unit 110 or the position information of the display screen changed by a virtual scroll and the average value of the panel signal presently input.

Since there are the first input device 250-1 and the second input device 250-2 in the invention, the input-device driver 140 performs the signal control on the first input device 250-1 and the signal control on the second input device 250-2.

Under the control of the time controller 125 and the control unit 110, a switching element 145 alternately connects the first input device 250-1 and the second input device 250-2 to the input-device driver 140.

The alternate connection means that the signal generated from the first input device 250-1 is first processed and the signal generated from the first input device is then processed, that is, that the signals from the input devices 250-1 and 250-2 are alternately processed in a time division manner.

In this case, the time is divided into very small time pieces such as one over ten seconds, one over ten hundred seconds, and one over million seconds, and thus it is possible to sufficiently cope with the case where information is manually input.

Here, a signal driver is used to drive two or more input devices. However, the number of input-device drivers may be set to correspond to the number of input devices.

The input-device driver may be a component independent of the central processing unit or may be a component incorporated into the central processing unit.

Fig. 15 is a flowchart illustrating the flow of processes in the invention.

When the portable display device is started up, the body controller 105 is started up to control the units thereof (step 400).

The control unit 110 in the body controller 105 divides the screen display data stored in the memory 120 or the received screen display data. This function is performed by the display driver 130 and the time controller 125 under the control of the control unit 105 (see Figs. 12 and 13).

Accordingly, the body controller 104 divides the screen and transmits the screen data corresponding to the first display panel and the second display panel (step 402).

Then, the input-device driver 140 drives the first input device 250-1 through the use of the switching element 145 shown in Fig. 14. That is, information output from the first input device is controlled (step 404). The information output from the first input device is controlled on the basis of the screen display information of the first display panel 2 (step 4060. The method of controlling the input device on the basis of the display information is the same as described with reference to Fig. 14.

Similarly, the input-device driver controls the output signal of the second input device through the use of the switching element 145 (step 408), and controls the output signal of the second input device on the basis of the screen display information of the second display panel (step 410). This step is the same as described with reference to Fig. 14.

When a stop command is not given, the body controller continues the screen and drives the input devices. When a stop command is given, such functions are stopped (steps 412 and 414).

That is, the input-device driver controls the information output from the first input device on the basis of the screen information of the first display panel and controls the information output from the second input device on the basis of the screen information of the second display panel. By repeatedly performing the control of the input-device driver, two input devices can be controlled as if they are a single input device.

As a result, the first display panel and the second display panel divide a single screen vertically or horizontally, the first display panel and the second display panel are contiguous to each other, and the first input device corresponding to the output information of the first display panel and the second input device corresponding to the output information of the second display panel are also contiguous to each other so as to use two input devices as a signal input device.

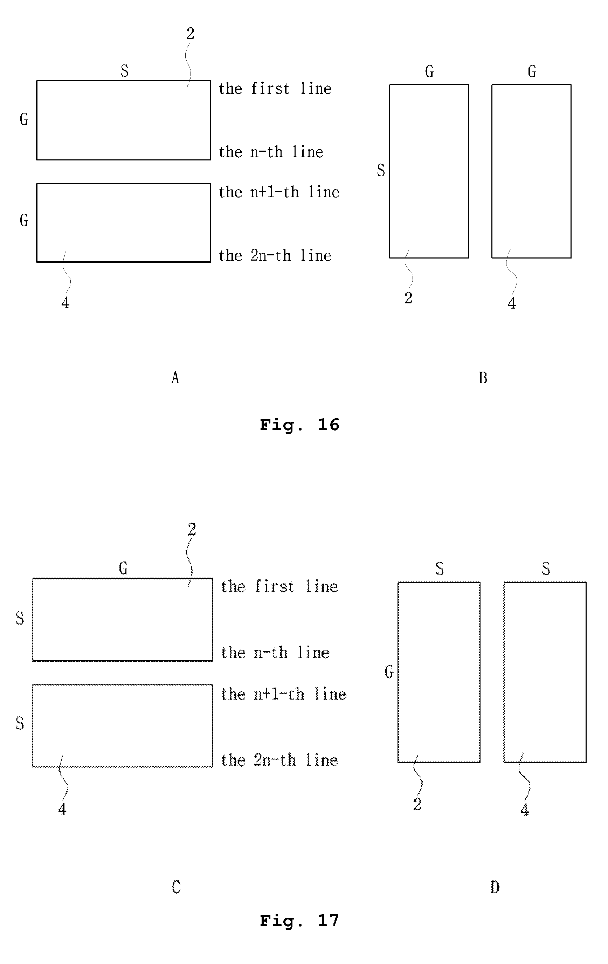

Figs. 16 and 17 are diagrams illustrating the driving method.

Fig. 16 is a diagram illustrating an example where the gate electrodes are divided like Fig. 12. That is, the first display panel 2 includes the first to n-th gate lines and the second display panel 4 includes the (n+1)-th to 2n-th gate lines.

In this case, the driving signals (the driving signals of the first display panel) of the first to n-th lines and the driving signals (the driving signals of the second display panel) of the (n+1)-th to 2n-th lines are separately sent.

When the display panels 2 and 4 are vertically arranged, the gravity sensor determines the normal state (A in the drawing). When the display panels 2 and 4 are horizontally arranged, the gravity sensor determines the abnormal state (B in the drawing).

Fig. 17 is a diagram illustrating an example where the source electrodes are divided like Fig. 13. That is, the first display panel 2 includes the first to n-th source lines and the second display panel 4 includes the (n+1) -th to 2n-th source lines.

In this case, the data signals (the data signals of the first display panel) of the first to n-th lines and the data signals (the data signals of the second display panel) of the (n+1)-th to 2n-th lines are separately sent.

When the display panels 2 and 4 are vertically arranged, the gravity sensor determines the normal state (C in the drawing). When the display panels 2 and 4 are horizontally arranged, the gravity sensor determines the abnormal state (D in the drawing).

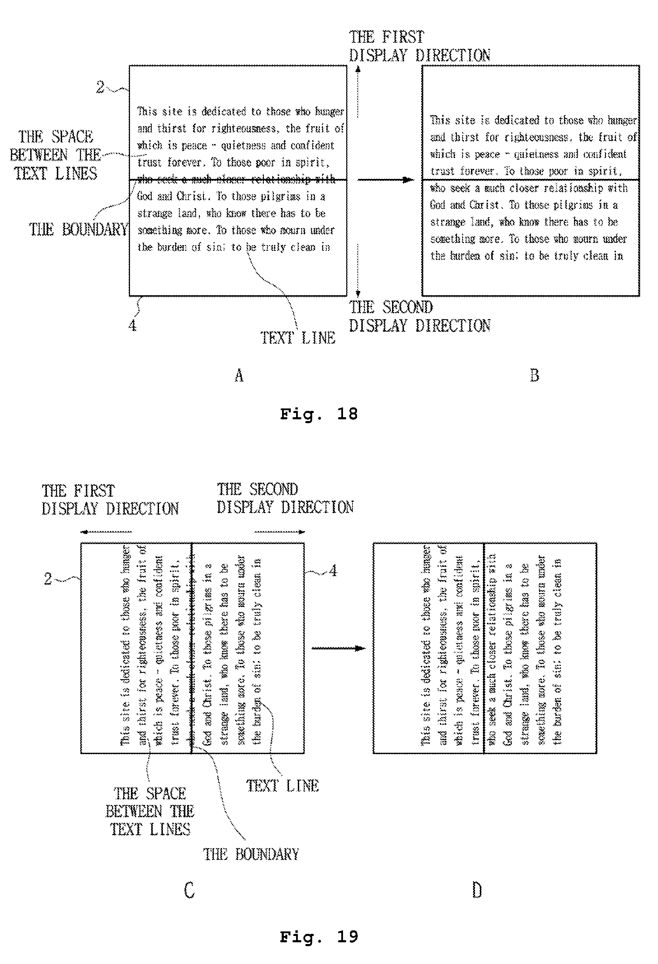

Figs. 18 and 19 are diagrams illustrating screen patterns.

Fig. 18 is a diagram illustrating the screen pattern in the normal state.

That is, A in Fig. 18 shows the state where a text line or a text image is located in the boundary. As shown in the drawing, a text line is located in the boundary as the joint between the display panels 2 and 4.

B of Fig. 18 shows the state where the screen is shifted downward and the boundary between the display panels is located between the text lines.

Fig. 19 is a diagram illustrating a screen pattern in the abnormal state. C of Fig. 19 shows the state where a text line or a text image is located in the boundary. As shown in the drawing, a text line is located in the boundary as the joint between the display panels 2 and 4.

D of Fig. 19 shows the state where the screen is shifted to the left or right and the boundary is located between the text lines.

As a result, the screen can be shifted toward the first display panel or the second display panel. The direction in which the screen is shifted toward the first or second display panel is indicated by arrows in Figs. 18 and 19.

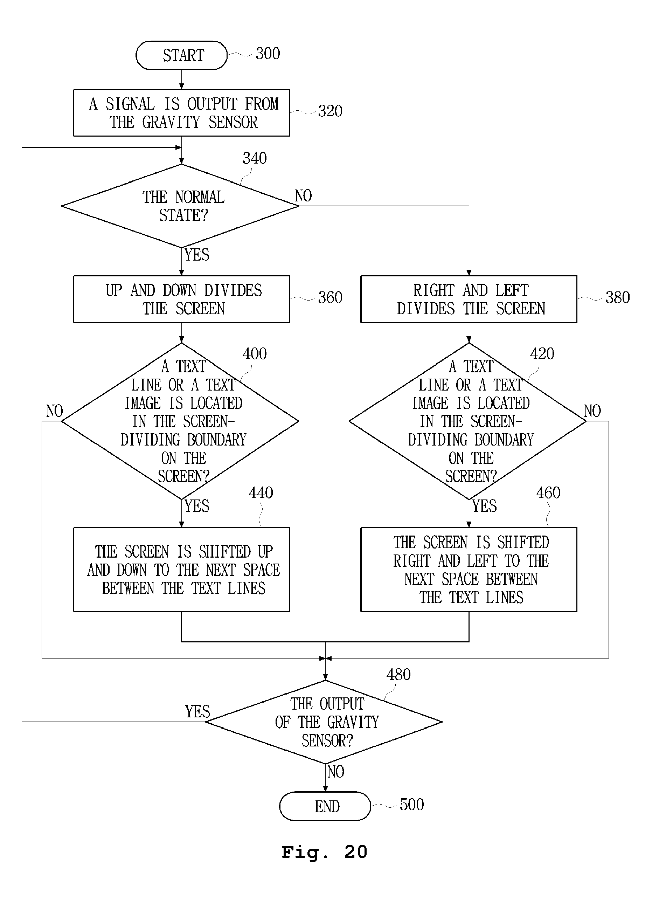

Figs. 20 to 24 show algorithms of causing a text line not to be located in the boundary between the display panels.

Referring to Fig. 20, the algorithm is started (step 300) by the activation of the gravity sensor. When a signal is output from the gravity sensor (step 320), the central processing unit 105 determines whether it is in the normal state or the abnormal state (step 340). The normal state and the abnormal state in the invention are assumed in the same way as shown in Figs. 16 and 17. The central processing unit 105 vertically divides the screen when it is in the normal state (step 360), and horizontally divides the screen when it is in the abnormal state (step 360).

It is determined whether a text line or a text image is located in the screen-dividing boundary on the screen in the normal state (step 400). When it is determined that a text line or a text image is located in the screen-dividing boundary, the screen is shifted vertically to the next space between the text lines (step 420).

Similarly, it is also determined whether a text line or a text image is located in the screen-dividing boundary on the screen in the abnormal state (step 440). When it is determined that a text line or a text image is located in the screen-dividing boundary, the screen is horizontally shifted to the next space between the text lines.

In both case, when it is determined a text line is not located in the screen-dividing boundary, the algorithm may be performed again on the basis of the output of the gravity sensor. Similarly, even when the screen is shifted to the next space between text lines, the algorithm may be performed again.

On the other hand, the screen may be shifted manually through the use of the input device or the menu button. That is, by setting a manual change mode for the screen shift, the screen is not automatically shifted even when a text line or a text image is located at the boundary.

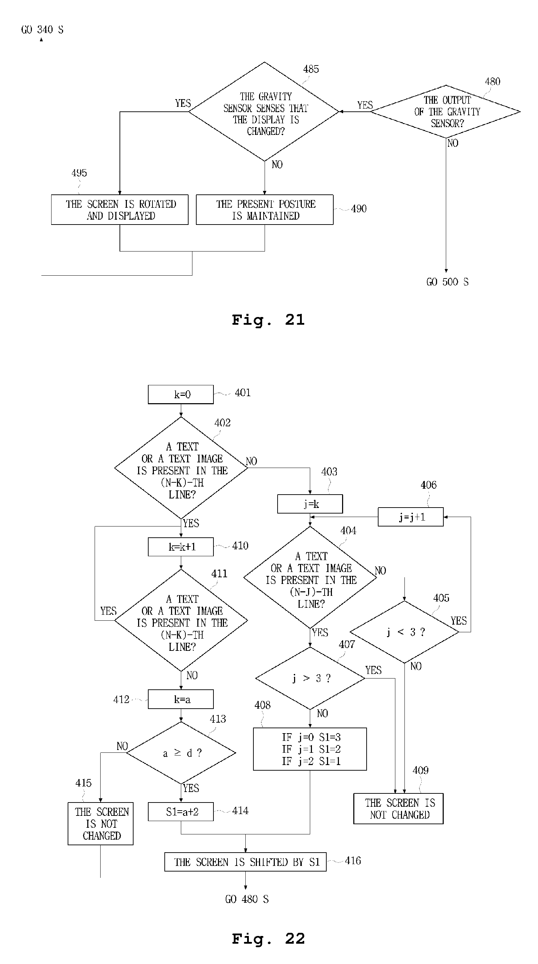

Fig. 21 is a diagram illustrating an algorithm of selecting a screen on the basis of the output of the gravity sensor.

That is, Fig. 21 is a flowchart illustrating a process of displaying a screen with rotation of 90 degrees in the algorithm shown in Fig. 20.

The algorithm is repeated depending on the output of the gravity sensor (step 480). When the gravity sensor senses that the posture of the display device is changed (step 485), the screen is rotated and displayed (step 485). When the posture of the display device is not changed, the present posture is maintained (step 490).

That is, the gravity sensor senses the rotation of 90 degrees in the invention. When the rotation of 90 degrees is sensed (step 485), the central processing unit 200 rotates and displays the screen by 90 degrees. In this case, the entire screen is rotated in the state where the first display panel and the second display panel form a single screen. After the rotation of the screen has been performed, the process of step 340 is performed.

Fig. 22 is a diagram illustrating the algorithm of shifting the screen in the algorithm shown in Fig. 20.

The algorithm of steps 400 to 460 in the algorithm shown in Fig. 20 is shown in detail in Fig. 22. The first display panel includes the first to n-th lines and the second display panel includes the (n+1)-th to 2n-th lines. The n-th line of the first display panel and the (n+1)-th line of the second display panel are closest to the boundary.

In Fig. 22, it is determined whether a text (or a text image) is present in the boundary of the first display panel 2. Here, the text represents letter data in an actual text file and the text image represents image data indicating the image of letters. That is, the actual text data may be displayed on the screen or the text image indicating the image of text may be displayed on the screen.

At the time of starting the algorithm, "k=0" is set (step 401). It is then determined whether a text or a text image is present in the (n-k)-th line (step 402). When it is not determined in step 402 that a text or a text image is present in the (n-k)-th line, "j=k" is set (step 403) and then it is determined whether a text or a text image is present in the (n-j)-th line (step 404).

When it is determined that a text or a text image is present in the (n-j)-th line, it is determined whether j is smaller than 3 (step 405). When the determination result is affirmative, the value of j is changed (step 406). When the determination result is negative, the screen is not shifted but is maintained in the present state.

When the determination result in step 404 is affirmative, it is determined whether j is greater than 3 (step 407). When it is determined that j is smaller than 3, S1 is set to 3, 2, and 1 as j is changed to 0, 1, and 2 (step 408). When it is determined that j is greater than 3, the screen is not shifted but is maintained in the present state.

That is, when a text or a text image is not present in the boundary, the presence of a text (or a text image) is checked while reducing the line one by one from the boundary. When a text (or a text image) is not present up to the third line, the screen is not shifted but is maintained in the present state.

When a text or a text image is not present from the boundary to the third line, it means that a text or a text image is not present around the boundary (that is, when a photograph or a figure is present) or that the boundary is located between the text lines. In this case, the screen does not have to be shifted, which is determined through the algorithm.

When the determination result in step 407 is negative, it is set to display a text image apart by at least three lines from the boundary in step 408. For example, when a text or a text image is apart from the boundary by one line, the text image is excessively adjacent to the boundary to cause a problem in visibility. Accordingly, the value of S1 is determined so that the screen is shifted to get apart the text image by two lines from the boundary. That is, when j=1, S1=2.

When the determination result in step 402 is affirmative, k is changed (step 410). It is then determined whether a text or a text image is present in the (n-k)-th line (step 411). When the determination result is affirmative, the process of step 411 is repeatedly performed. When the determination result is negative, k is changed to a (step 412).

It is then determined whether a is equal to or greater than D (step 413). The screen is maintained in the present state (step 415) when the determination result is affirmative, and the value of S1 is determined (step 414) when the determination result is negative. That is, the value of S1 is set to a+2.

When the value of "S1" is determined through the above-mentioned algorithm, the screen is shifted vertically or horizontally by S1. The shift is performed toward the second display panel. The shift of the screen to the first or second display panels is shown in Figs. 18 or 19.

The value of D is a predetermined numerical value. For example, when D is 20, it means that letters are large enough not to be influenced by the joint as the boundary and thus the joint does not hinder the recognition of letters. In this case, the screen is not shifted but is maintained in the present state. This is because the letters are large to be present from the boundary to the 20-th line.

When a text (or a text image) is present from the boundary to the (D-1)-line, the screen is shifted so that the text (or the text image) is not present in the boundary. In this case, by setting the amount of screen shift to a+2, the text image is apart by two or more lines from the boundary. This is performed to prevent the text image from being present adjacent to the boundary.

In some cases, the amount of screen shift may be set to a+3 or a+4. That is, when the size of pixels in the screen is smaller, the amount of screen shift may be changed.

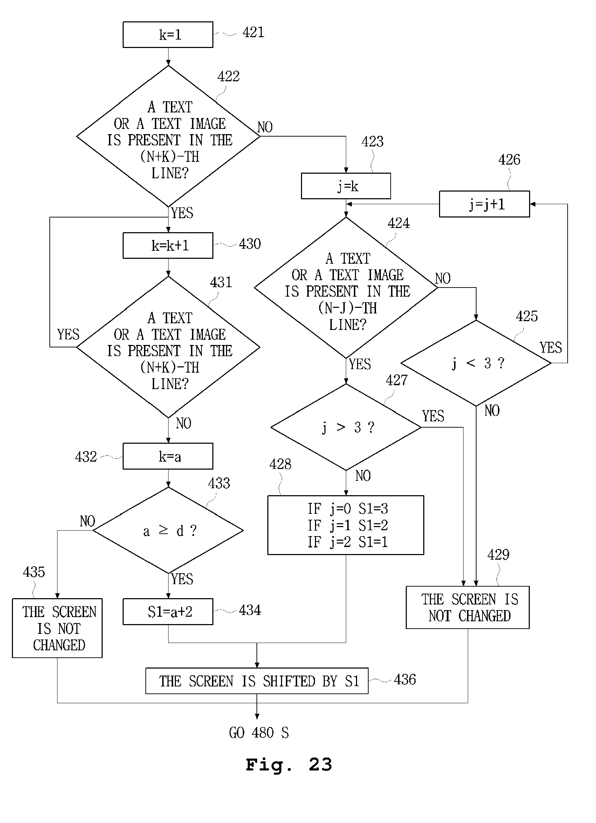

Fig. 23 is an algorithm of determining whether the screen should be shifted in the boundary of the second display panel.

This algorithm has the same principle as the first display panel and is performed with an increase from the (n+1)-th line one by one. When the value of S2 is determined in the algorithm, the screen is shifted toward the first display panel by S2.

The same algorithm is applied to both cases where two display panels are arranged vertically or two display panels are arranged horizontally. The same algorithm is also applied to both cases where the gate lines are divided or the source lines are divided so as to divide the screen into two screens.

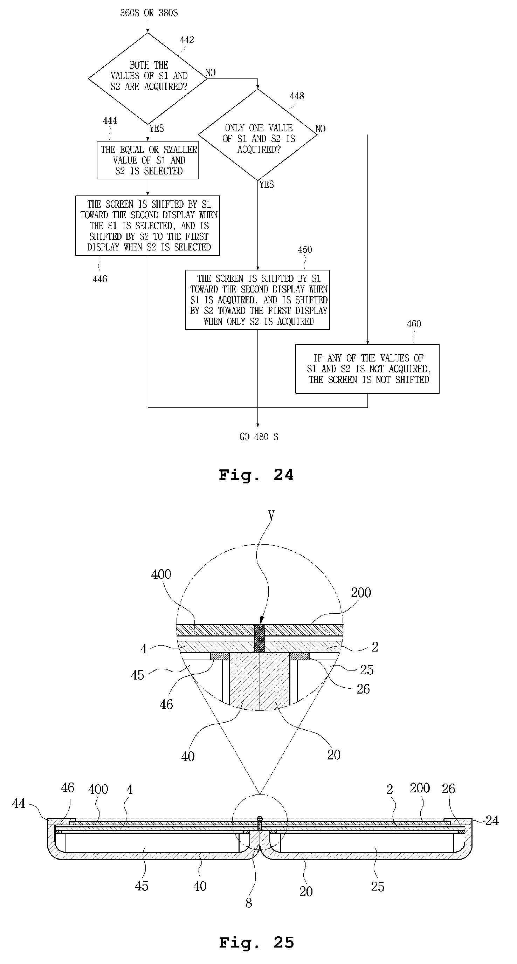

Fig. 24 is a diagram illustrating an algorithm of shifting a screen using the acquired value.

It is determined whether both the values of S1 and S2 are acquired through the algorithms shown in Figs. 22 and 23 (step 442). When both values are acquired, the equal or smaller value of S1 and S2 is selected (step 444). The screen is shifted by S1 toward the second display panel 4 when the value of S1 is selected, and is shifted by S2 to the first display panel 2 when the value of S2 is selected (step 446).

For example, when the value of S1 is 3 and the value of S2 is 4, the value of S1 is selected and the screen is shifted by 3 lines toward the second display panel. When the values of S1 and S2 are both 4 (step 444), the number 4 is selected and the screen is shifted by 4 lines.

It is determined whether only one value of S1 and S2 is acquired (step 448). When only one value is acquired, the value is selected. That is, the screen is shifted by S1 toward the second display panel when only the value of S1 is acquired, and is shifted by S2 toward the first display panel when only the value of S2 is acquired (step 450).

That is, when only the value of S1 is acquired and the value of S1 is 3, the screen is shifted by 3 lines toward the second display panel.

When the determination result in step 448 is negative, any of the values of S1 and S2 is not acquired. In this case, the screen is not shifted. That is, the screen is shifted neither vertically nor horizontally.

The algorithms shown in Figs. 20 to 24 can be applied to strip-like images. That is, the screen can be shifted by recognizing repeated strip patterns and applying the algorithms thereto. The strip patterns or the text lines are recognized using known image recognizing methods. That is, a method of analyzing the size of data by lines and the like may be used or a program of visually analyzing an image may be used.

Fig. 25 is a diagram illustrating an example where the display panels and the input devices are separated apart by the same distance from each other.

As shown in the drawing, when a portion marked by "V" is formed of protective films, the protective films should be as thin as possible but as strong as possible. Accordingly, the protective films can be formed of a metal film or a resin film or may be formed of a material obtained by coating a resin film with metal or inorganic substance.

When the portion marked by "V" is formed of the protective films or protective members, the thickness thereof is preferably in the range of 0.005 mm to 0.5 mm. In this case, the sealing function is rather important than the protecting function from a physical impact. The distance between two display panels 2 and 4 is in the range of 0.01 mm to 1 mm. Similarly, the distance between two input devices 200 and 400 is in the range of 0.01 mm to 1 mm.

Compared with the case where the protective member is formed thin and the sealing function is rather important than the protecting function from a physical impact, the side surfaces of the display panels 2 and 4 or the side surfaces of the input devices 200 and 400 can be more satisfactorily protected from a physical impact by the use of the side cover 18 shown in Fig. 2.

However, the protective member (the portion marked by V) may be formed in a plate shape with a thickness of 1 mm or less so as to protect the sides surfaces of the display panels 2 and 4 and the input devices 200 and 400 from a physical impact. In this case, the distance between two display panels 2 and 4 is in the range of 0.1 mm to 2 mm. Similarly, the distance between two input devices 200 and 400 is in the range of 0.1 mm to 2 mm.

The portion marked by "V" may not be formed of a particular protective member but may be unified with the panel housings. In this case, the sides surfaces of the display panels 2 and 4 and the side surfaces of the input devices 200 and 400 are protected by the side walls of the panel housings 20 and 40.

In Fig. 25, the portion marked by "V" is thinner than the sidewalls of the panel housings 20 and 40, which is intended to reduce the distance between the display panels as much as possible. That is, when the portion marked by "V" is thinner than the side walls of the panel housing, its thickness is preferably less than 1 mm and more preferably less than 0.5 mm.

The portion marked by "V" may have a thickness equal to or slightly greater than the thickness of the sidewalls of the panel housings 20 and 40. However, when the portion is excessively thick, the product quality is lowered.

It is preferable that the thickness of the sidewalls of the panel housings is not greater than 1.5 mm. Accordingly, the portion marked by "V" is not preferably greater than 1.5 mm. The thickness of the portion marked by "V" is preferably not greater than 2 mm, even when it is thicker than the sidewalls of the panel housings 20 and 40.

Conclusively, the distance between the display panels 2 and 4 is in the range of 0.1 mm to 4 mm. In order to set the distance between the display panels 2 and 4 to 4 mm, it is not necessary to set the thickness of the portion marked by "V" to 2 mm. That is, a certain gap may be interposed between the side surfaces of the display panels 2 and 4 or the input devices 200 and 400 and the portion (the sidewalls or the protective members) marked by "V".

For example, even when the thickness of the portion marked by "V" is 0.5 mm, the distance between the display panels 2 and 4 may be 4 mm. That is, the invention provides a structure for reducing the distance between two display panels 2 and 4.

Therefore, it is preferable that the distance between the display panels 2 and 4 is in the range of 0.1 mm to 4 mm. When the side surfaces of the display panels or the input devices are separated from the portion marked by "V", the space therebetween may be empty or may be filled with a buffer member absorbing an impact.

The distance between the joint 8 and the input devices 200 and 400 is in the range of 0.1 mm to 4 mm.

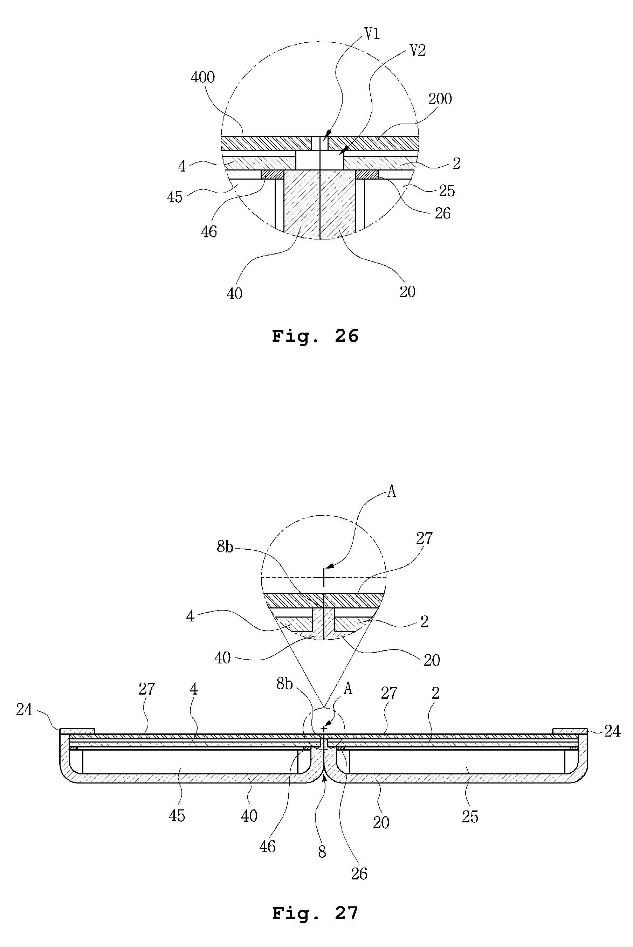

Fig. 26 is a diagram illustrating an example where the distance between the input devices is smaller than the distance between the display panels.

When a portion between the input devices 200 and 400 is marked by "V1" and a portion between the display panels 2 and 4 is marked by "V2", the width of "V1" is smaller than that of "V2". That is, the distance between the input devices is smaller than the distance between the display panels 2 and 4 200 and 400.

The portion marked by "V1" and the portion marked by "V2" may be unified with the sides walls of the panel housings 20 and 40.

Only the portion marked by "V2" may be unified with the sidewall of the panel housings 20 and 40 and the portion marked by "V1" may be formed of a protective film or a protective member. When the portion is formed of a protective film or a protective member, the protective member or film described with reference to Fig. 25 may be used.

Both the portion marked by "V1" and the portion marked by "V2" may be formed of a protective member other than the panel housings. In this case, the side surfaces of the display panels 2 and 4 and the side surfaces of the input devices 200 and 400 in the joint are protected by the protective member.

The thickness of the portion marked by "V1" is the same as shown in Fig. 25, except that the width thereof is smaller than the thickness of the portion marked by "V2". For example, When the portion marked by "V1" is formed of a film type, the thickness may be less than 0.5 mm. When the portion marked by "V1" is formed of a plate type, the thickness may not be greater than 1.5 mm.

Therefore, in the example shown in Fig. 26, the distance between the input devices 200 and 400 is less than 3 mm. In order to set the distance between the input device 200 and 400, it is not necessary to set the thickness of the portion marked by "V1" to 1.5 mm.

That is, even when the thickness of the portion marked by "V1" is 0.5 mm, the distance between the input devices 200 and 400 may be 3 mm. The input devices 200 and 400 and the portion marked by "V1" may be separated from each other to a certain extent. When they are separated from each other, the space therebetween may be empty or may be filled with a buffer member absorbing an impact.

The distance between the display panels is greater than the distance between the input devices, but the portion marked by "V2" is set in the same way as the portion marked by "V1".

The portion "V1" attached to the side surface of the first display panel 2 and the portion "V1" attached to the side surface of the second display panel 4 may have the same thickness, but may have different thicknesses depending on the designs.

Figs. 27 to 29 are diagrams illustrating an example where an optical member is provided.

Fig. 27 shows an example where the display panels 2 and 4 are closely attached to the sidewalls of the panel housings 20 and 40 and an optical member is mounted on the top 8b of the sidewalls of the panel housings. The portions of the sidewalls of the panel housings 20 and 40 to which the display panels are closely attached are thinner than the other portions of sidewalls.

However, the portions of the sidewalls of the panel housings 20 and 40 to which the display panels 2 and 4 are closely attached may not be thinner as shown in Figs. 25 and 26. Accordingly, the distance between the display panels 2 and 4 is the same as described above in the examples.

The optical members 27 may be mounted on the display panels. The optical member serves to refract light, like a lens, a micro lens, and a micro prism and may include all types of members changing the optical path toward the joint 8.

The optical member also serves to reduce the non-display area between the display panels. Therefore, the optical members are disposed to come in contact with each other. A protective film may be disposed on the side surfaces of the optical members 27.

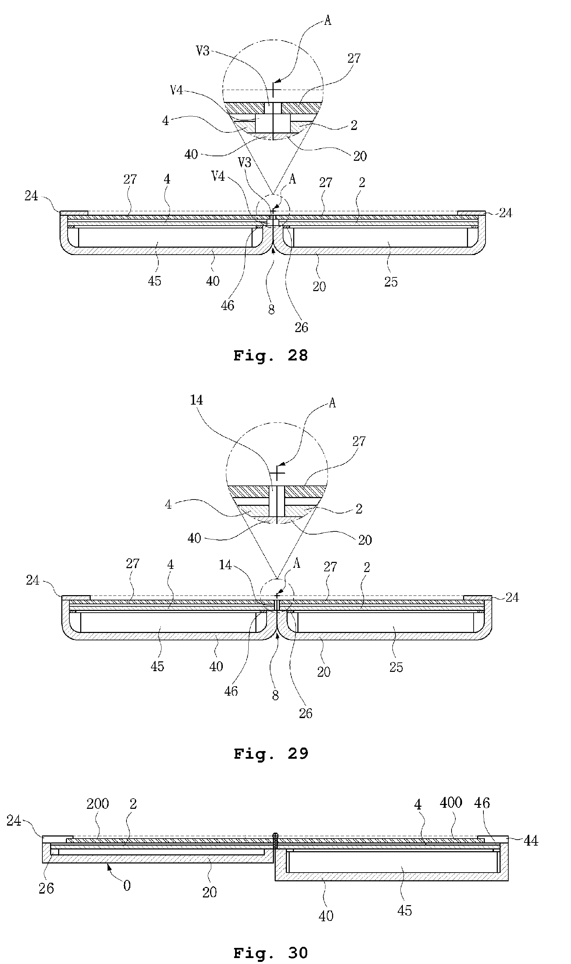

In Fig. 28, a portion marked by "V3" and a marked portion by "V4" are present between optical members 27 and between the display panels 2 and 4. The portions "V3" and "V4" may be unified with the sidewalls of the panel housings 20 and 40 or may be formed of particular protective member separated from the panel housings 20 and 40. The protective member may be formed of transparent or opaque plastic resin or alloy metal.

The portions "V3" and "V4" may have a thickness smaller than the sidewalls of the panel housings 20 and 40, or may have a thickness equal to that of the sidewalls, or may have a thickness larger than the sidewalls.

When the portions "V3" and "V4" are transparent, the outer surface may be coated with a colored material or a colored film may be additionally attached thereto. This is because the color thereof is equal to the color of the side surfaces of the panel housings.

The distance between the display panels is preferably equal to or less than 4 mm and the distance between the optical members 27 is preferably equal to or less than 2 mm

Fig. 29 is a diagram illustrating an example where protective films 14 are provided to the display panels 2 and 4 and the optical members 27. As shown in the drawing, the protective films are provided to reduce the distance therebetween. The thickness of the protective films is less than 0.5 mm.

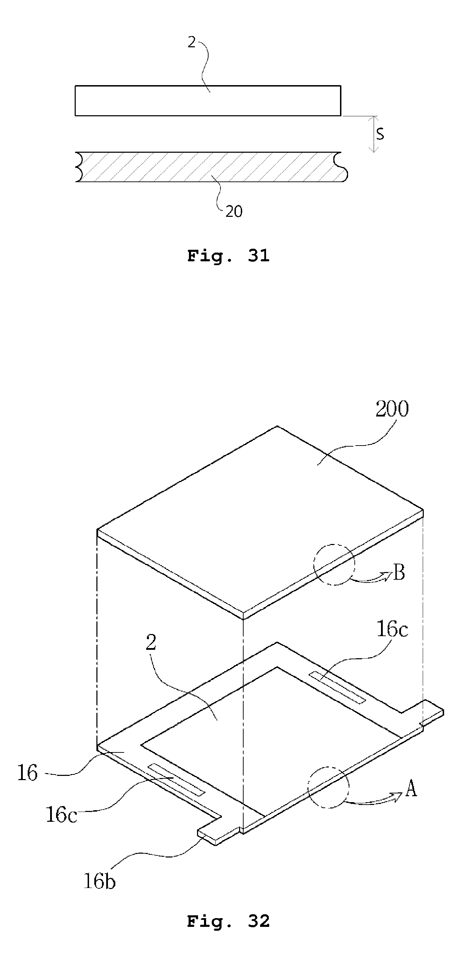

Figs. 30 and 31 are diagrams illustrating an example where the arrangement of the display panels and the components.

As shown in the drawings, the thicknesses of the panel housings 20 and 40 may be set to be different from each other. The panel housings 20 and 40 in the invention serve as a case of a portable display device.

The display panel 2 and the input device 200 are disposed just above the bottom of one panel housing 20 and the body controller or the central processing unit and a battery is disposed on the other panel housing 40.

That is, components such as a battery, the body controller, and a body board are disposed below the display panel 4 in the other panel housing 40.

In Fig. 31, the distance S between the bottom of the panel housing 20 having a smaller thickness and the display panel is shown. Both may be in close contact with each other to make the distance therebetween zero or may form a space therebetween. The distance S is preferably less than 2.5 mm.

Although not shown in the drawings, a display support absorbing an impact or a sheet-like impact absorbing plate may be interposed between the bottom of the panel housing 20 and the display panel.

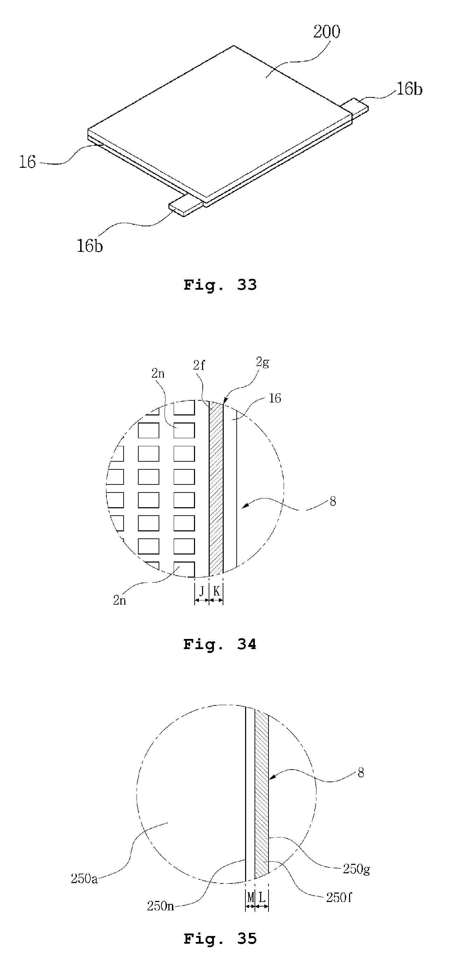

Figs. 32 and 33 are diagrams illustrating an example where an input device is mounted on a display panel.

The input device 200 is disposed on the chassis 16 mounted with the display-relevant components. Adhesive portions 16c are disposed at the edges of the chassis 16 so as to adhere the input device thereto. The adhesive portions 16c may employ a double-sided adhesive tape or an adhesive.

Fig. 32 shows a state where the chassis and the input device are detached from each other and Fig. 33 shows a state where the input device 200 is mounted on the display panel 2 or 4.

The chassis is not necessarily formed of metal but may be a structure formed of a plastic resin. The combination of the metal and the plastic structure may be employed. The chassis in the invention commonly means a structure mounted with display components.

Fig. 34 to 36 show the detailed configuration of a display panel and an input device.

Fig. 34 is an enlarged view of the part marked by a circle A in fig. 32.

In the invention, two screens are joined to each other to minimize the size of the joint. Accordingly, the display panels should be designed to reduce the joint.

As shown in the drawing, the distance J between the pixels 2n closest to the joint 8 and the partition wall 2f is less than 1 mm. The value of J may be set to 0.

The thickness K of the partition wall 2f is in the range of 0.01 mm to 1 mm. Accordingly, the distance from the pixel 2n closest to the joint to the edge 2g of the display panel 2 or 4 is set to be less than 2 mm.

The partition wall 2f means the boundary between the inside and the outside of the display panel. A sealant may be used as the partition wall. The sealant may be formed of glass when the substrate of the display panel is formed of glass, or may be formed of metal when the substrate of the display panel is formed of metal. The partition wall commonly means a portion distinguishing the inside from the outside in the side surface of the display panel 2 or 4 (a component performing a function of displaying a screen).

On the other hand, the display panel 2 or 4 is mounted on a chassis. The chassis is normally formed of metal such as aluminum or alloy thereof. A display module is formed by mounting the display panel and the display panel driver or a backlight (when the display panel is an LCD) on the chassis.

The chassis does not have to be formed of metal and may be formed of a structure of a plastic resin. The metal and the plastic structure may be combined. The chassis in the invention commonly means a structure mounted with display components.

The thickness of the chassis 16 at the joint 8 is in the range of 0.01 mm to 1 mm. More preferably, the thickness 16 is not greater than 0.5 mm. Accordingly, the distance between the pixels 2n closest to the joint 8 and the edge of the chassis 16 is equal to or less than 2.5 mm.

The edge 2g of the display panel and the edge of the partition wall 2f do not have to be completely matched with each other in the joint 8. The edge of the partition wall 2f can be located within 0.5 mm from the edge 2g. In this case, the distance between the pixels 2n closest to the joint 8 and the edge of the chassis 16 is equal to or less than 3.0 mm.

That is, the width of the non-display area of the joint is the total sum of the value of J, the value of K, and the thickness of the chassis and is equal to or less than 3.0 mm. When two display panels are joined to each other, the width of the non-display area is equal to or less than 6 mm.

The chassis 16 is not necessarily disposed on the side surface of the display panels 2 and 4 in the joint. A simple protective film may be provided instead of the chassis 16 in the joint.

The structure shown in Fig. 34 can be applied to display devices of a flat display panel type.

Fig. 35 is an enlarged view of the circle B shown in Fig. 32.

The input devices can be mounted on the display panels 2 and 4. When the input devices are mounted on the display panels 2 and 4, the design of the two input devices should also be changed so as to use two input devices like a single input device.

The input device is normally mounted on the display panel and serves to input or select information.

That is, lead lines for reading resistance values from the input device are disposed on the side of the input device. The position of a bus (electrode line) 250n in the joint should be changed. The partition wall 250f is present.

Fig. 35 shows an example of a resistance type having a structure in which two substrates (formed of transparent plastic) coated with a transparent electrode are coupled to each other.

The distance M between the bus 250n and the partition wall in the joint 8 is equal to or less than 1 mm. The thickness L of the partition wall 250f is in the range of 0.01 mm to 1 mm. Here, the distance M may be 0 mm.

The partition wall is used to mutually couple conductor films 220 or to the input device to couple another plate.

Accordingly, the distance between the electrode line 250n and the edge 250g of the input device 200 in the joint 8 is equal to or less than 2 mm. Alternatively, the distance between the edge of an active area 250a and the edge 250g of the input device 200 is equal to or less than 2 mm. Here, the active area means an area which is coated with a conductor and to which information can be input.

The edge 250g and the edge of the partition wall 250f do not have to be completely matched with each other in the joint 8. The edge of the partition wall 250f can be located within 0.5 mm from the edge 250g. In this case, the distance between the electrode line 250n and the edge 250g is equal to or less than 2.5 mm.

The partition wall 250f does not have to be disposed depending on the type of the input device such as a capacitance type. In such a capacitance type, the distance between the edge 250g and the electrode line 250n is equal to or less than 2 mm. Similarly, the distance between the edge of the active area and the edge 250g is equal to or less than 2 mm.

The input device in the invention is not limited to the capacitance type and the resistance type, but may be of any type in which it is formed of a flat plastic or glass plate and information is input through the use of the flat surface.

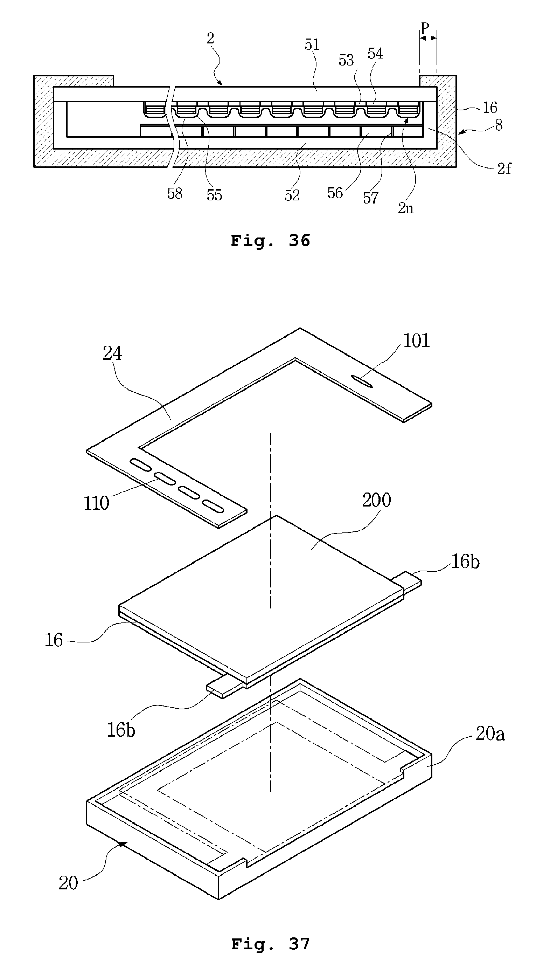

Fig. 36 is a sectional view of the display panel, where the pixel electrodes are located closer to each other in the joint.

An LCD can be used as the display panel. In addition, an OLED or an electronic paper can be used as the display panel. In any flat display panel, the distance between the display edge 2g and the closest pixels 2n in the joint 8 is very significant. The designed values in the invention can be applied to all the flat display panels.

The portable display device according to the invention employs an OLED type and the sectional view of the structure is shown in the drawing.

Each of the display panels includes insulating layers 53, electrodes 54, coating electrodes 58, and an organic multi-layered film 55 on a substrate 51. The display panel may further include moisture-absorbing layers 56 with isolation films 57 interposed therebetween.

The substrate 51 is covered with a lid substrate 52. Here, the partition wall 2f may be a sealant formed of an adhesive or the like. The substrate may serve as the partition wall 2f.

That is, when a substrate is partially removed by an etching process to form a space in the substrate and the insulating layers, the organic multi-layered films, the electrodes, and the like are formed therein, the edge portions of the substrate left by the etching process can be used as the partition wall 2f.

In the joint, the chassis covers the side surfaces, and when the chassis covers upper side, the chassis covers only the portion P corresponding to the non-display area.

The structure shown in Fig. 36 is not applied only to the OLED type but also applied to all the types of flat display panels.

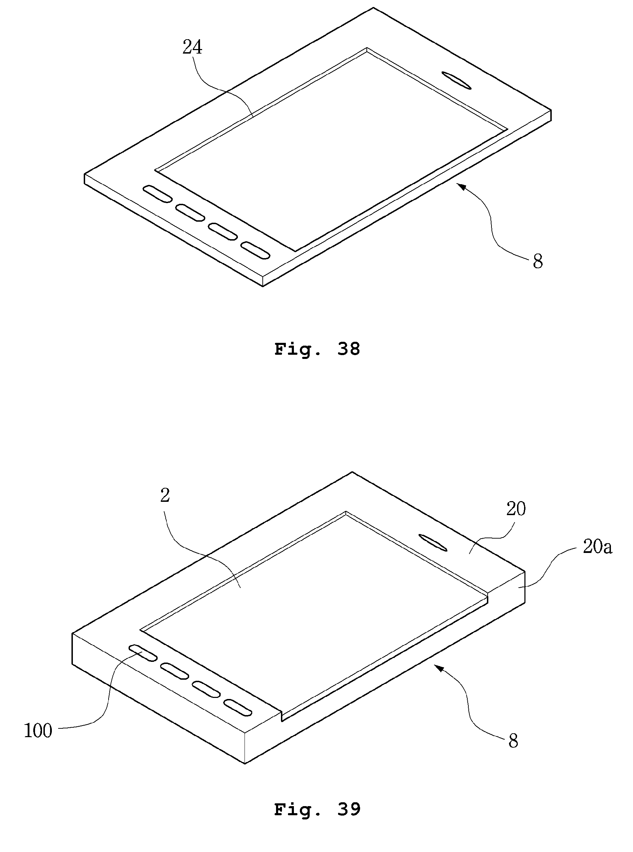

Figs. 37 and 38 show an example where a display having an input device attached thereto is mounted on a panel housing.

In Fig. 37, a joint 8 of a display panel 2 including an input device 200 is located on a sidewall 20a of a panel housing.

A ⊂-shaped lid 24 is disposed on the panel housing 20 to cover the edge as the non-display area of the display panel 2.

Input buttons 110, a speaker 101, and the like may be disposed in the lid.

Fig. 38 shows a □-shaped lid, where the joint is formed thin. As shown in the drawing, the width of the lid 24 in the joint is smaller.

Since the lid 24 covers the non-display area and the portion of the non-display area in the joint is thinner than other portions, the width of the lid in the joint is smaller than the other widths.

Fig. 39 is a perspective view illustrating a panel housing mounted with a display panel.

An image display area is present in a display panel and is called an active area. The active area is located closer to the joint. That is, the width of the non-display area in the joint is smaller.

The display panel 2 is shown in the drawing, but the display panel 2 is mounted with an input device 200. The reference numeral of the input device is not marked for the purpose of easy understanding.

The □-shaped lid (see Fig. 38) can be mounted on the panel housing. The width of the lid 24 in the joint is smaller.

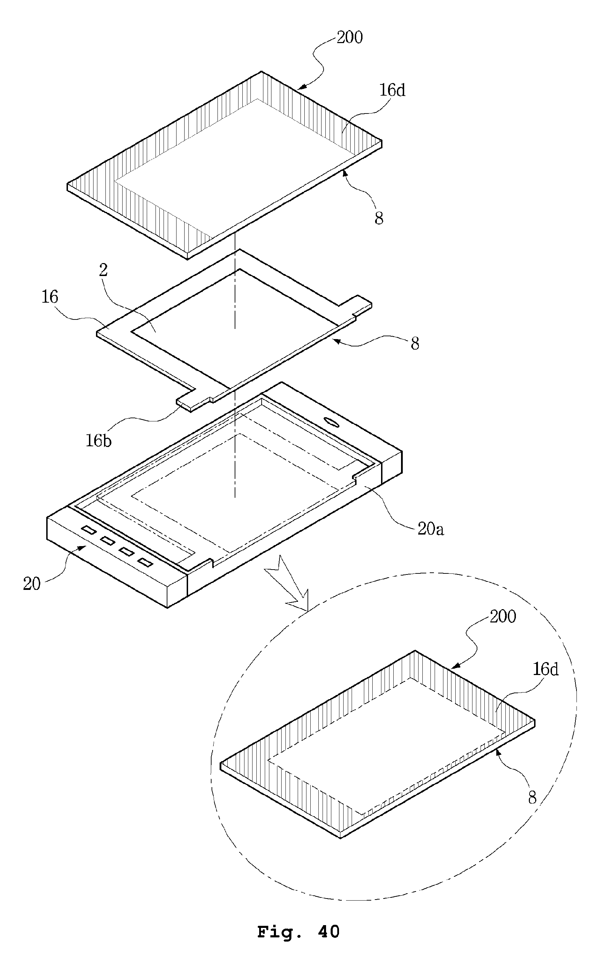

Fig. 40 is a diagram illustrating an example where a display panel and an input device are separately mounted on a panel housing.

As shown in the drawing, the display pane12 and the input device 200 are separately mounted on the panel housing 20 and the lid 24 shown in Figs. 37 to 39 is not disposed.

Accordingly, the input device 200 also serves as a protective plate protecting the surface of the display panel 2 of the portable display device.

A c-shaped printed mask 16d or a pattern is formed in the input device 200. The printed mask 16d masks the non-display area in the edge of the display panel 2. This mask has a visual effect.

When a mask is printed on the input device 200, it means that a mask is printed on a protective film, a protective plate, or a window plate on the input device.

As shown in the circle of the drawing, the mask 16d may have a □ shape. The width of the mask in the joint is reduced.

The active areas of the display panels are located closer to each other in the joint and the non-display area in the joint is smaller. Accordingly, the width of the printed mask 16d is smaller.

The input device in the invention is not limited to the capacitance type and the resistance type, but may be of any type in which it is formed of a flat plastic or glass plate and information is input through the use of the flat surface.

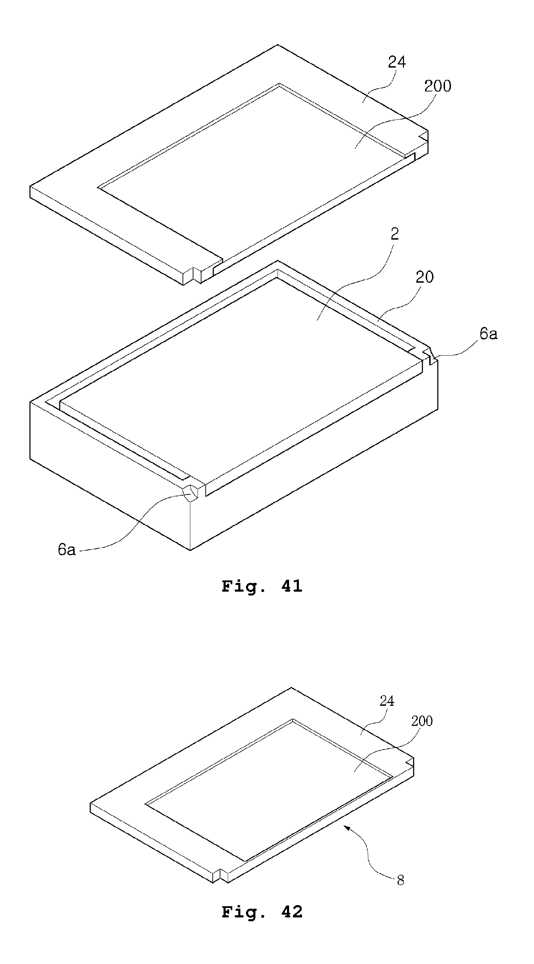

Figs. 41 to 44 are diagrams illustrating other examples where the display panel and the input device are separately mounted on the panel housing.

The display panels 2 and 4 are mounted on the panel housings 20 and 40, respectively, and the input devices 200 and 400 are mounted thereon. The input devices 200 and 400 are assembled with the ⊂-shaped lids 24 and the resultants are disposed on the display panels 20 and 40.

The ⊂-shaped lids 24 and the panel housings 20 and 40 are fastened to each other with coupling screws or the like, which is a conventional coupling structure and thus is not shown in the drawing.

The lid 24 and the input device 200 or 400 have a level difference which is equal to or less than 2 mm.

Cutouts 6a are formed in the panel housings 200 and 400 and joint members are disposed in the cutouts 6a.

Fig. 42 shows an example where an input device is mounted on a □-shaped lid. The lid has a smaller width in the joint. The reason is the same as described with reference to Figs. 37 to 40.

The □-shaped lid is mounted in the same way as the ⊂-shaped lid.

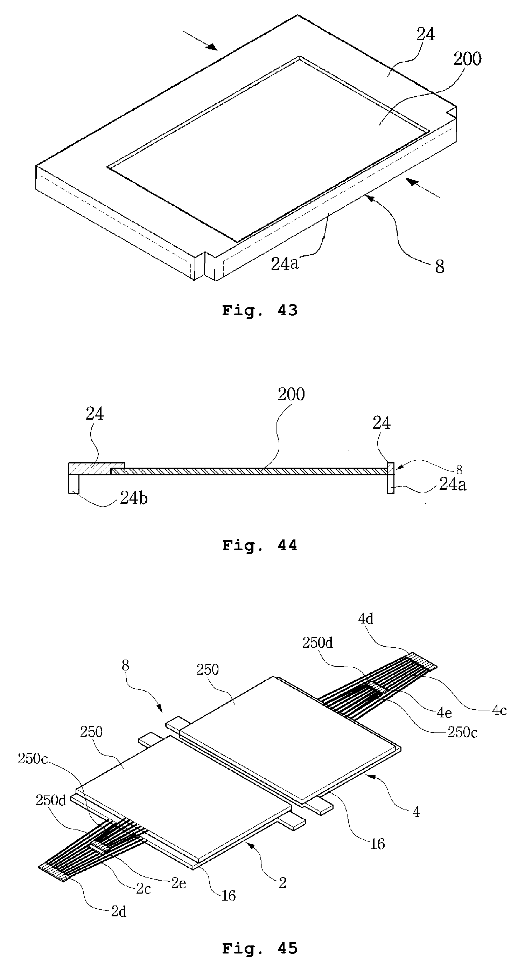

Fig. 43 shows a lid having a frame shape. The lid 24 has a lid sidewall 24a at the edges as shown in the drawing. The lid has a frame shape to serve as a lid and a sidewall of a panel housing. Accordingly, the lid sidewall 24a can be in close contact with the side surface of the display panel 2 or 4 or the side surface of the input device 200 or 400 in the joint 8.

Fig. 44 is a sectional view (taken along the arrow line of Fig. 43), where the lid sidewall 24a is disposed at the edge of the lid 24.

The lid sidewall 24a coming in close contact with the side surface of the display panel, the side surface of the input device, and the side surface of the optical member is disposed on the bottom of the lid 24 in the joint.

A sidewall 24b having the same function as the sidewall of the panel housing 20 or 40 is disposed on the bottom of the lid 24 other than the joint. The sidewall 24b is not essential.

The lid 24 may not be provided to the joint 8. That is, the lid 24 may be disposed in only the place other than the joint.

The lid sidewall 24a works in the same way as the sidewall of the panel housing. That is, the lid sidewall 24a may be cut out so as to reduce the distance between the display panels 2 and4 or the distance between the input devices 200 and 400. A part of the lid sidewall may be replaced with a protective member or a protective film for protecting the side surface of the display panel 2 or 4 or the side surface of the input device 200 or 400.

Some examples can be present in the joint. First, both the side surface of the display panel 2 or 4 and the side surface of the input device 200 or 400 can be in close contact with the sidewall of the panel housing 20 or 40. Second, the side surface of the input device 200 or 400 can be in close contact with the lid sidewall 24a and the side surface of the display panel 2 or 4 can be in close contact with the sidewall of the panel housing 20 or 40.

Third, both the side surface of the input devices 200 or 400 and the side surface of the display panels 2 or 4 can be in close contact with the lid sidewall 24a.

Fourth, the side surface of the input device 200 or 400 and the side surface of the display panel 2 or 4 can be in close contact with the sidewall of the panel housing 20 or 40 and the lid sidewall 24a at a predetermined ratio. That is, only a part of the side surface of the input device can be in close contact with the lid sidewall, or only a part of the side surface of the input device and a part of the side surface of the display panel can be in close contact with the lid sidewall.

In all of four examples, the sidewall may be cut out or the sidewall may be replaced with a protective member.

The lid 24 including the lid sidewall 24a or the lid 24 not including the lid sidewall can be coupled to the panel housing 20 or 40 through the use of protrusions or level differences or through the use of screws. Conventional coupling methods can be employed and thus are not shown in the drawing.

The lid is designed to provide rigidity to the panel housing. Accordingly, a metal material such as alloys or liquid metal can be used in addition to the plastic resin.

Fig. 45 is a diagram illustrating the actual arrangement of the display panels and the input devices.

Connectors are used to connect display panels and input devices to a main body of a display device. In the invention, the positions of the connectors can be changed in design.

As shown in the drawing, the display panels 2 and 4 and the input devices 200 and 400 are disposed symmetric about the joint 8. Here, flexible printed circuits (FPC) 2c, 4c, and 250c are disposed to connect the display panels and the input devices to connectors 2d and 250d. The FPCs 2c, 4c, and 250c are disposed opposite to the joint.

The connectors 250d of the input devices 200 and 400 are electrically connected junctions 2e and 4e of the display panels 2 and 4. Accordingly, the input devices 200 and 400 are electrically connected to the main body with the electrical connection of the connectors 2d and 4d of the display panels 2 and 4 to the main body. That is, the connectors 2d and 4d of the display panels have a function as connectors of the input devices.

As a result, the external signal lines (FPC) are connected to one side of each display panel and each input device. The external signal lines (FPC) are disposed opposite to the joint.

When the display panels 2 and 4 and the input devices 200 and 400 are separately mounted on the panel housings 20 and 40 (see Figs. 40 and 41), the external signal lines (FPC) can be connected to one side of each input device 200 among three sides other than the joint 8.

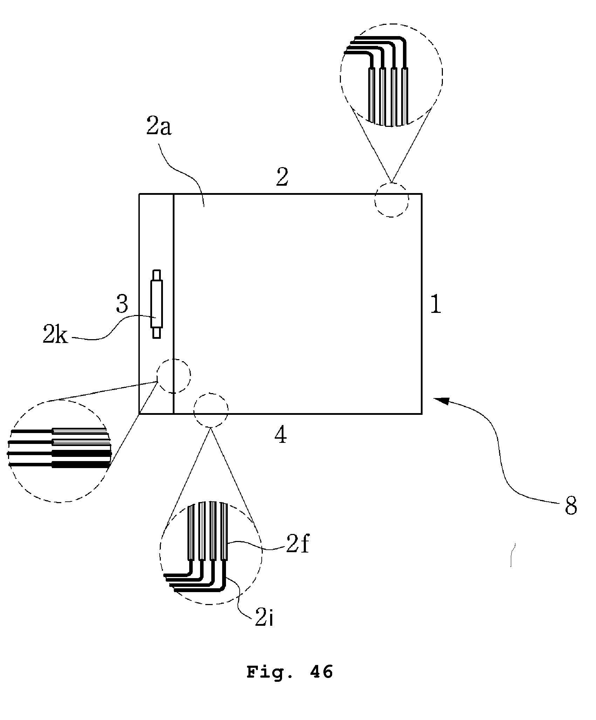

Fig. 46 is a diagram illustrating an electrode structure of a display panel.

A display panel generally includes a driving unit and a panel unit. In general, the display panel is formed of a glass substrate or a transparent plastic substrate.

As shown in Fig. 46 showing a display panel, when four sides of the display panel include first, second, third, and fourth sides and the first side is the joint, a driver 2k is mounted on the third side opposite to the joint.

In general, a display panel is driven in a matrix way and driving signals are sent to two sides. In this case, at least two drivers are necessary. Supply lines 2i connected to panel electrodes 2f on the second side and the fourth side are drawn to the third side. Accordingly, signals can be sent to the display panel through the use of only the driver 2k mounted on the third side.

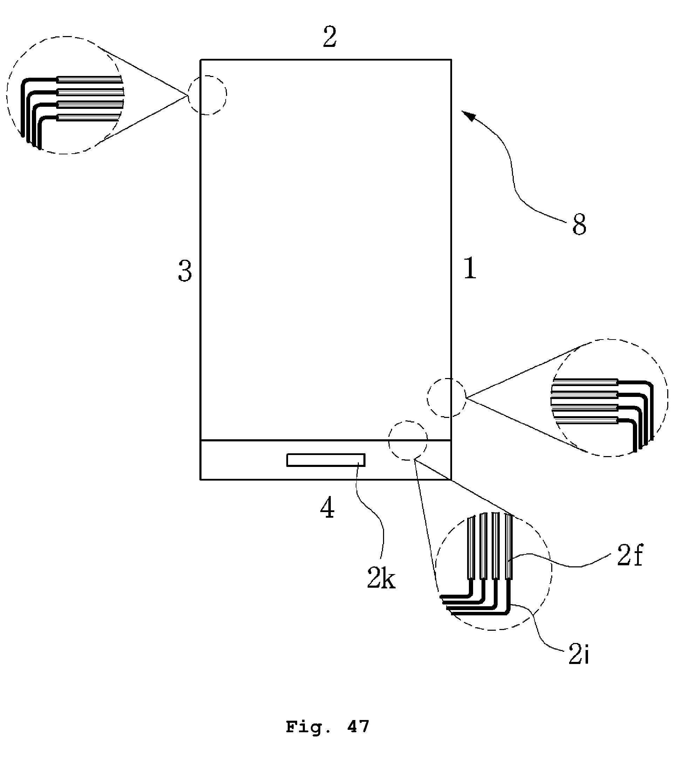

Figs. 47 to 49 are diagrams illustrating other examples of the display panels.

In Fig. 47, when the first side is the joint, the driver 2k is disposed on the fourth side. When the joint is disposed on the right side (left side in some cases), the driver 2k is disposed on the upper side or the lower side.

The supply lines 2i connected to the panel electrodes 2f on the first or third side are drawn to the fourth side so as to mount the driver 2k on the fourth side. That is, the supply lines 2i are drawn to the fourth side via the first and third sides. The supply line 2i is an electrical wire connected to the driver 2k to supply signals. The electrodes 2f in the invention may be thin film transistors (TFT) or pixel electrodes.

In this case, a margin of 1.5 mm is added to 2 mm which is the sum of the value of "J" and the value of "K" shown in Fig. 34. This is intended to guarantee a space passing the supply lines 2i. Accordingly, it is preferable that the distance from the pixels closest to the joint 8 to the boundary between the display panels 2 and 4 is not greater than 3.5 mm.

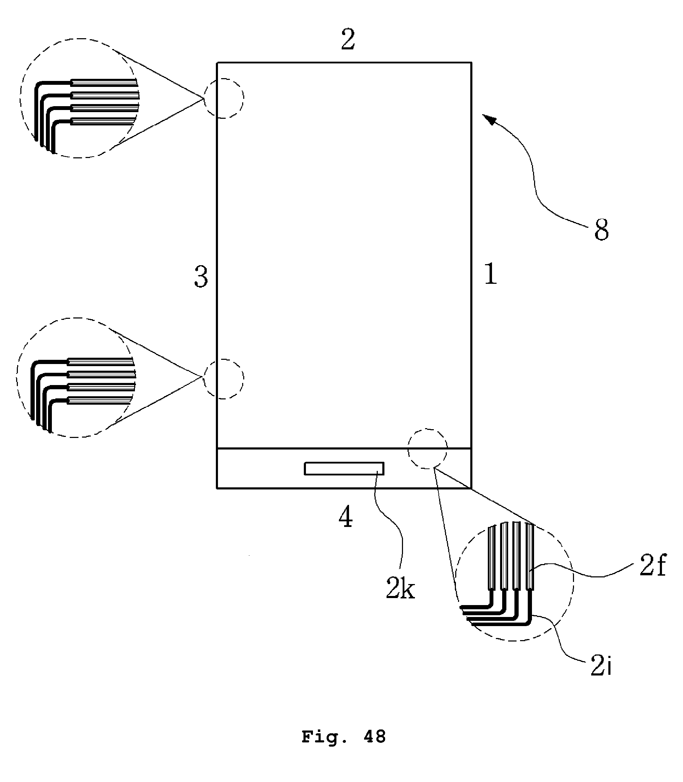

Fig. 48 is a diagram illustrating an example where the supply lines are modified.

When the first side is the joint, the supply lines 2i should not pass through the first side so as to minimize the width of the joint. The supply lines 2i are connected to the driver 2k via the third side opposite to the joint 8. Then, in the first side, the distance from the pixels closest to the joint 8 to the boundary between the display panels 2 and 4 can be set to be equal to or less than 2.0 mm.

Depending on some design conditions, more supply lines 2i can be designed to pass through the third side and less supply lines 2i can be designed to pass through the first side. That is, the supply lines 2i can be divided for the third side and the first side at a predetermined ratio.

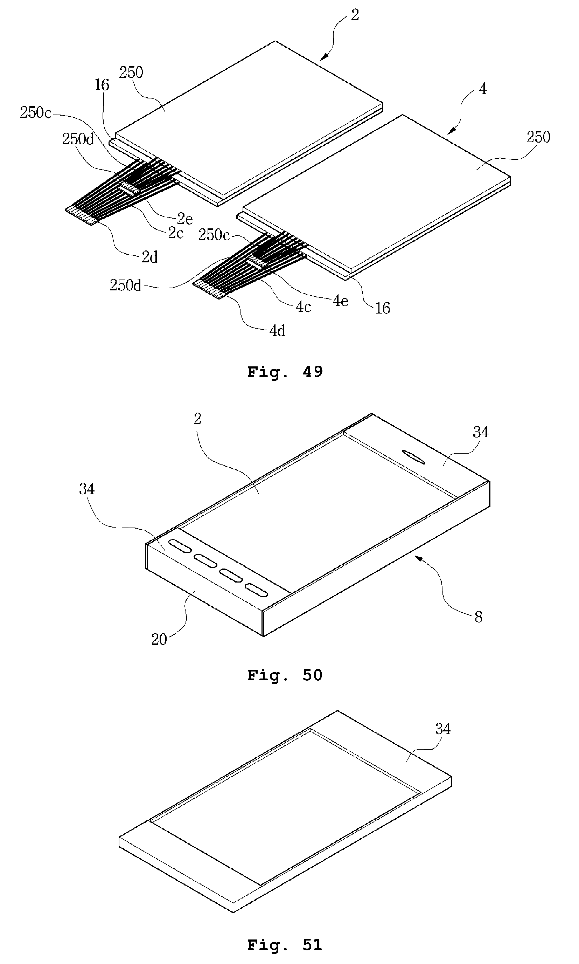

Fig. 49 is a diagram illustrating an example in which two display panels are arranged.

As shown in the drawing, when the joint 8 of the display panels 2 and 4 is the right side (the left side in some cases), the FPCs 2c and 4c or the connectors 2d and 4d connected to the driver are disposed on the lower side (the upper side in some cases).

Similarly, the FPCs 250c and the connectors 250d of the input devices are disposed on the lower side.

Figs. 50 to 53 are diagrams illustrating examples where a display panel is mounted on a panel housing.

As shown in Fig. 50, a =-shaped lid 34 covers the panel housing. The display panel shown in Figs. 47 and 48 is mounted on the panel housing 20 shown in Fig. 37. The =-shaped lid 34 is mounted thereon. The input device 200 may be mounted on the display panel 2 as shown in Fig. 49.

Both side surfaces of the display panel 2 are provided with the sidewall of the panel housing 20 or the protective member and the non-display area on the upper side or the lower side of the display panel 2 is covered with the =-shaped lid 34.

Fig. 51 shows another example of the lid, which is a □-shaped lid. The left and right sides of the "□" shape are thinner than the lower side.

The driver 2k of the display panels 2 and 4 is disposed on the lower side. When the lower side having the driver disposed thereon is located on the upper side, the right and left sides of the lid 34 are thinner than the upper side.

In the □-shaped lid shown in Figs. 47 and 48, the left side and the right side which are the first side and the third side, respectively, may be different from each other in width.

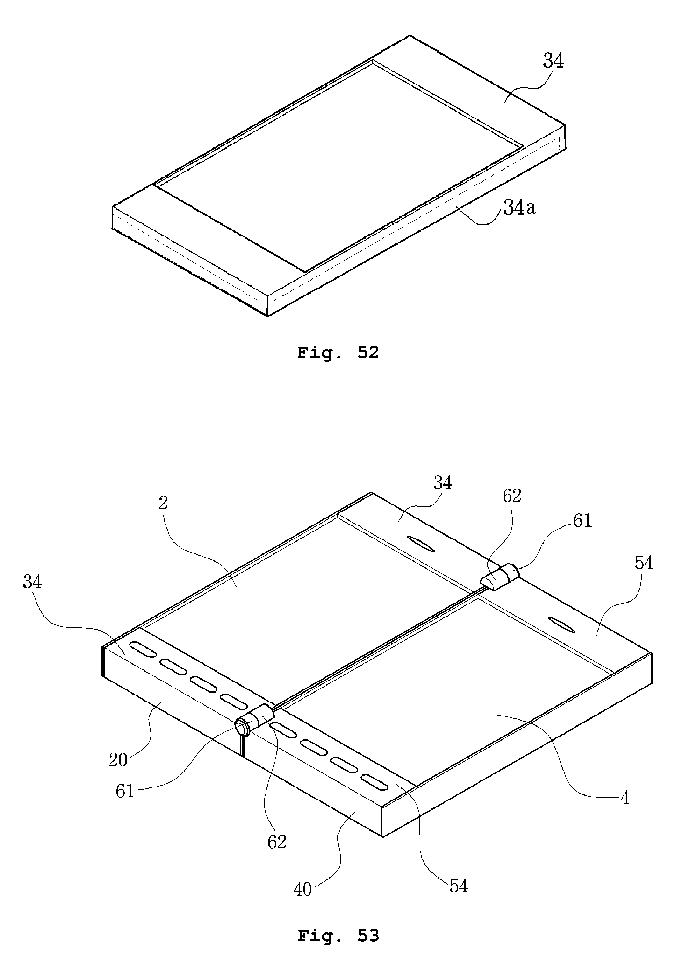

Fig. 52 shows an example where the lid 34 has a frame shape. Similarly to Fig. 43, a lid sidewall 34a is disposed on the edge of the lid. The lid sidewall 34a is similar to the lid sidewall 24a shown in Figs. 43 and 44.

Fig. 53 is a diagram illustrating the panel housings 20 and 40 mounted with the display panels 2 and 4 shown in Figs. 47 and 48 are joined to each other with joining shafts 61 and 62. The joint joining the display panels to each other is narrow as shown in the drawing. In this case, the screen is enlarged horizontally to form a large screen.

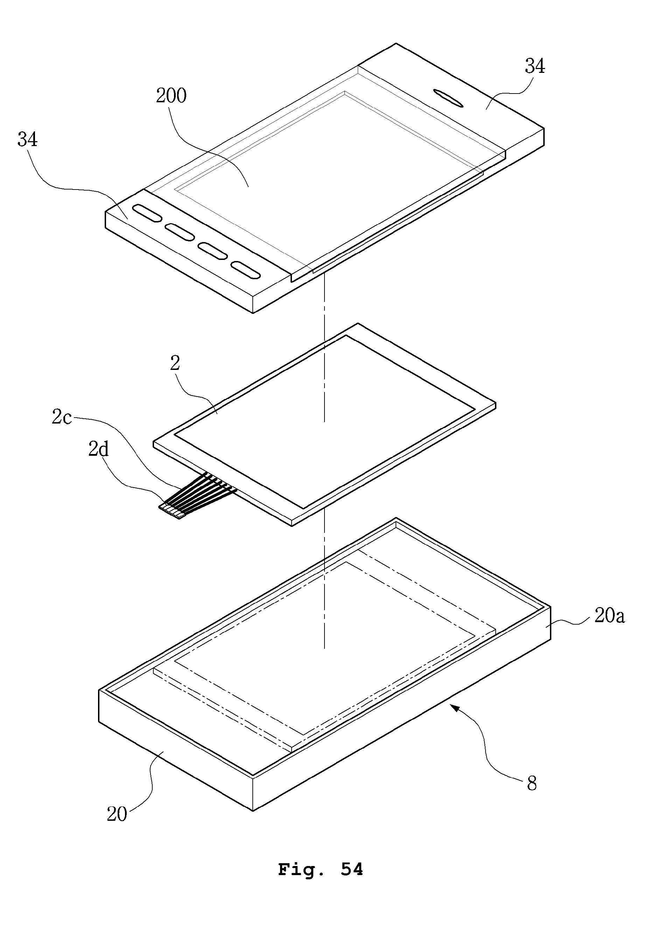

Fig. 54 is a diagram illustrating an example where an input device is mounted on the lid.

As shown in the drawing, the display panel is mounted on the panel housing 20 and the input device 200 is mounted on the panel housing 20 in a state where it is coupled to the lid 34. In this case, the lid has a "=" shape, but the lid 34 may have a "□" shape in which the right and left sides are thinner than the upper and lower sides.

When the input device is not necessary, a protective plate is used instead of the input device. In this case, a reinforced glass may be used.

The input device 20 may have a function of a protective plate. When the portable display device does not need the input device, a protective plate formed of a reinforced glass or a reinforced plastic may be disposed instead of the input device 200.

When the input device is separated from the display panel and is disposed on the top surface of the panel housing, as well as in the example shown in Fig. 54, a protective plate may be disposed on the input device.

In this example, the input device 200 is mounted on the lid 34, but the lid is not limited to this structure. That is, the lid may have a frame shape. In the frame shape, the lid has a sidewall so as to serve as a lid and a sidewall.

The lid having a sidewall can be mounted on the panel housing in the state where the input device is coupled to the lid.

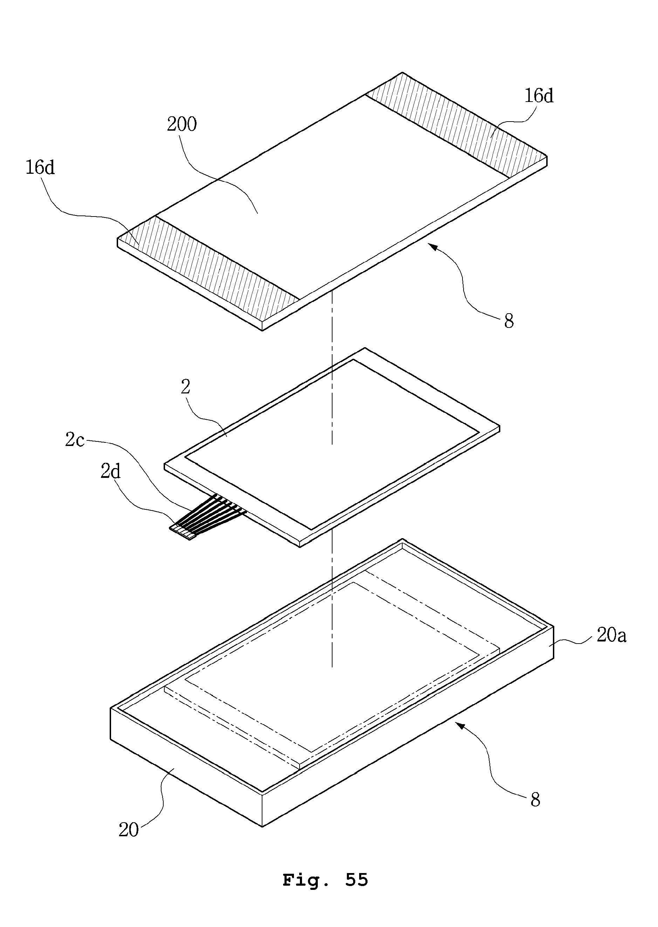

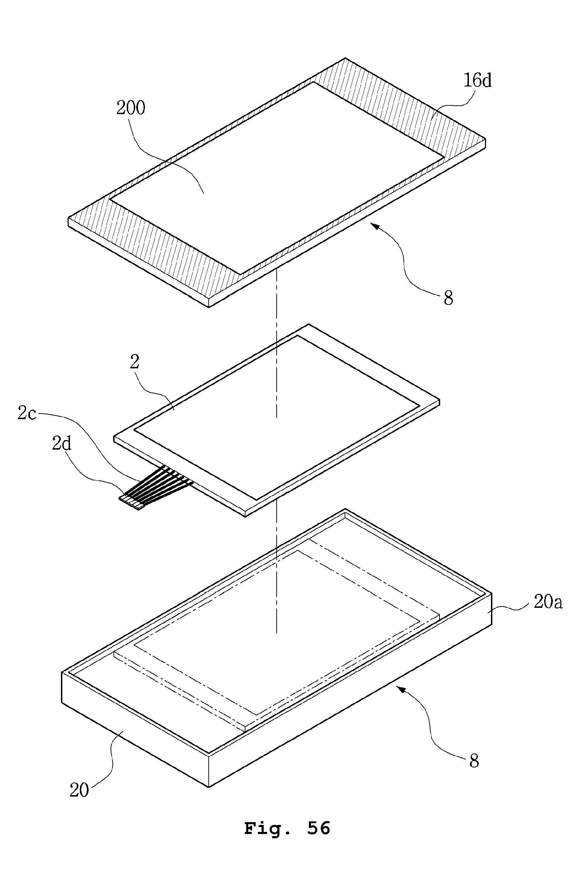

Figs. 55 and 56 are diagrams illustrating other examples of the input device.

Fig. 55 shows an example where the input device 200 having a function of a protective plate is directly mounted on the panel housing 20. As shown in the drawing, the input device having a =-shaped printed mask 16d is directly mounted on the panel housing. The display panel 2 is mounted on the panel housing in the same was as described above.

In Fig. 56, the input device 200 having a □-shaped printed mask is directly mounted on the panel housing 20. In this case, the right and left sides are thinner than the upper and lower sides.

The examples shown in Figs. 54 to 56 can be applied to the example shown in Fig. 53. That is, the panel housings 20 and 40 mounted with the display panels and the input devices are joined to each other with the joining shafts 61 and 62. When the panel housings 20 and 40 are unfolded, the display panels 2 and 4 are joined to each other.

When the input device is not necessary, a protective plate can be disposed instead of the input device.

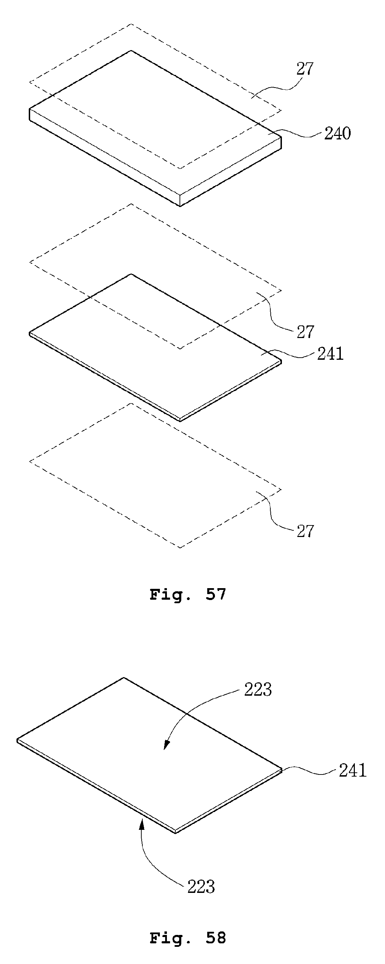

Figs. 57 to 59 are diagrams illustrating examples of the input device.

In Fig. 57 showing a capacitance type input device, a window or a protective plate 240 is disposed upside and a functional plate 241 having a transparent conductor layer or an ITO layer formed thereon is disposed under the window or protective plate. The printed mask 16d shown in Fig. 20 and the like is formed on the top surface or the bottom surface of the protective plate 240.

In the drawing, the optical member 27 is indicated by a broken line. That is, the optical member 27 can be disposed between the plates of the input device.

Fig. 58 is a diagram illustrating the functional plate. In the functional plate of a capacitance type, a single conductor layer 223 or two conductor layers 223 or more conductor layers may be formed. Accordingly, two functional plates coated with the conductor layer may be employed.

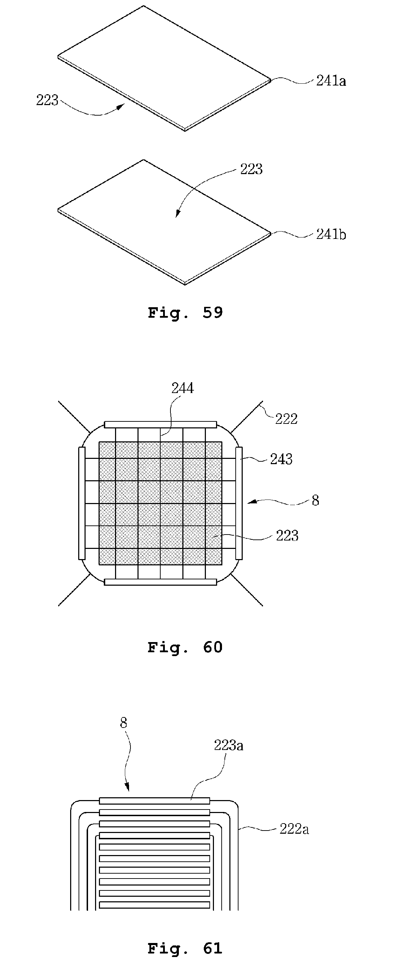

Fig. 59 shows an example where two functional plates 241a are employed and the conductor layer 223 is formed inside each functional plate. Two functional plates are coupled to each other with an insulating layer interposed therebetween.

Figs. 60 to 65 are diagrams illustrating patterns of the functional plate and lead lines.

In Fig. 60, a lattice-like electrode pattern 244 is formed in the conductor layer and is connected to the electrode lines 243, and lead lines 222 are disposed at four corners. When one side of the input device is used as the joint 8, the distance between the active area having the conductor layer formed therein and the edge of the input device in the joint is preferably equal to or less than 3 mm and more preferably equal to or less than 2 mm (see Fig. 35).

Accordingly, the electrode lines 243 are formed in the above-mentioned range in the joint.

Fig. 61 shows another pattern, where the conductor layer is patterned in stripes. The active area 223 of the input device is formed by a patterned conductor layer 223a.

The lead lines 222a are connected to both sides of the patterned conductor layer 223a. One side serves as the joint 8 and a side in which the lead lines are not formed is used as the joint.

When the width of the joint is equal to or less than 2 mm in spite of the lead lines, a side having the lead lines may be used as the joint.

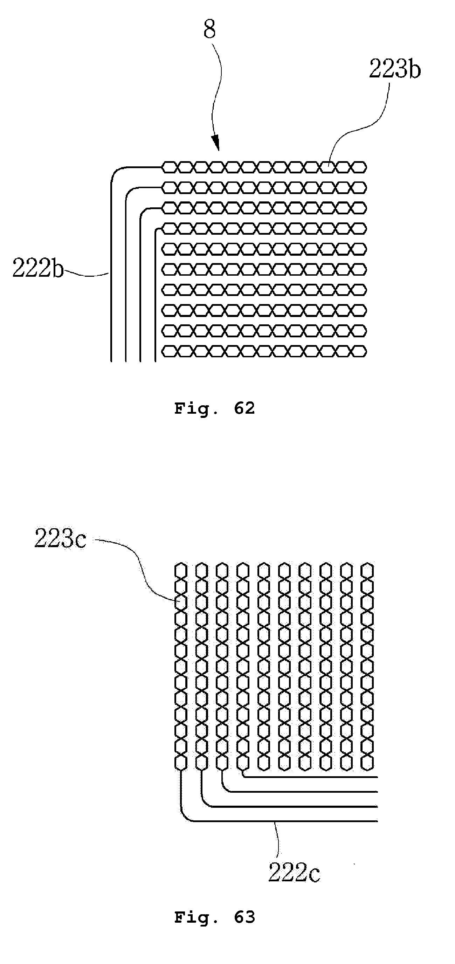

Figs. 62 to 64 are diagrams illustrating an example where the functional plate 241 has two layers. One layer has a pattern 223b formed therein as shown in Fig. 63 and the lead lines 222b are connected to one side thereof. The other layer has a pattern 223c and lead lines 223c formed therein as shown in Fig. 63.

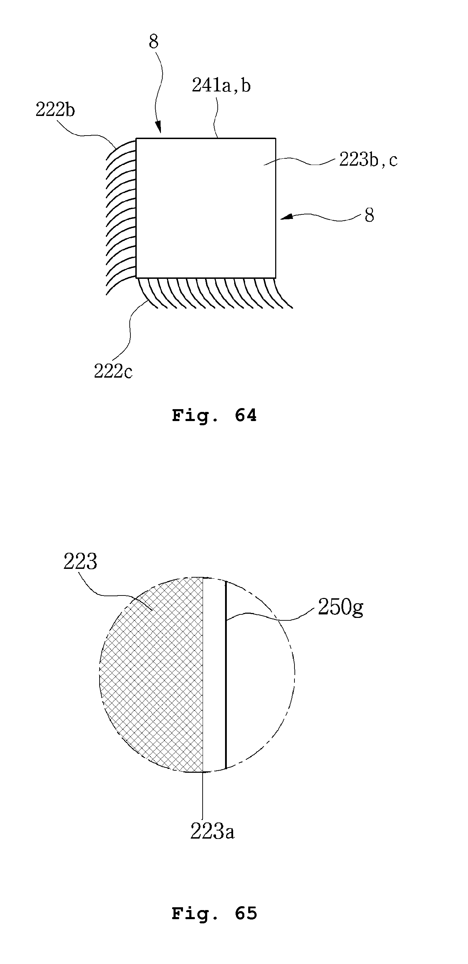

In Fig. 64, two layers are coupled to each other. That is, two patterns 223b and 223c and two sets of lead lines 222b and 222c are formed. The joint in which the input devices are joined to each other is formed on one side of each input device. A side not having the lead lines 223b and 223c formed thereon is selected as the joint.

When the distance between the active area and the edge of each input device is equal to or less than 2 mm, a side having the lead lines 223b and 223c formed thereon can be selected as the joint.

A smaller number of lead lines may pass through the joint and a larger number of lead lines may pass through the other sides.

The invention is not limited to the examples of the input devices described in this specification, but may be applied to all the input devices used to input information to a flat panel.

Fig. 65 is a diagram illustrating the active area and the edge of the input device. As shown in the drawing, no electrode line is disposed between the edge 223a of the active area 223 and the edge 250g of the input device. The distance between the edge 223a of the active area and the edge 250g of the input device is less than or equal to 2 mm.

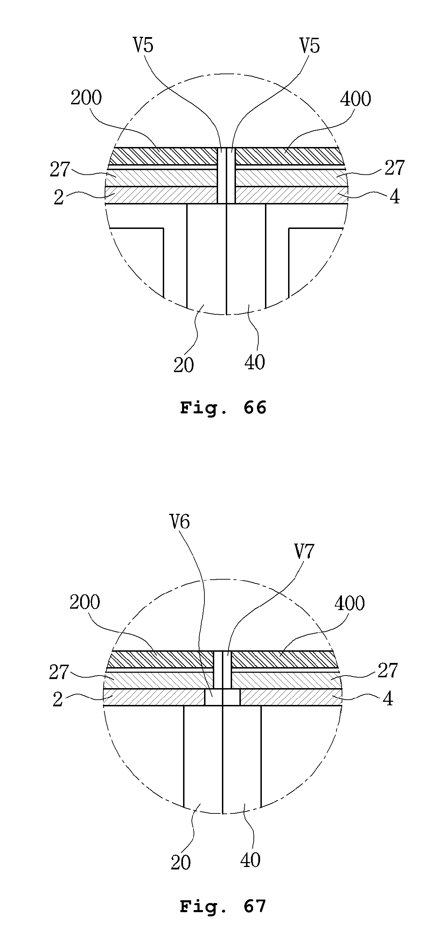

Figs. 66 to 68 are diagrams illustrating examples where both the input device and the optical member are disposed on the display panel.

In the example shown in Fig. 66, the optical members 27 are disposed on the display panels 20 and 40 and the input devices 200 and 400 are disposed thereon.

The display panels 2 and 4 have a non-display area resulting from the partition wall (or the sealant 2f) or the chassis 16, and the optical member 27 performs the function of reducing the width of the joint in the non-display area.

The portions "V5" on the side surfaces of the display panels 2 and 4, the optical members 27, and the input devices 200 and 400 include the protective films or the sidewalls of the panel housings.

The protective films may be of a coating type. The protective films may have a sealing function rather than a protecting function from a physical impact by setting the thickness to tens of micrometers or equal to or less than 0.2 mm, or may have a protecting function by setting the thickness to the range of 0.5 mm to 1 mm.

The portions "V5" may be unified with the panel housings 20 and 40. In this case, the thickness of the portions "V5" may be equal to, greater than, or less than that of the panel housings 20 and 40.

Fig. 67 is a diagram illustrating an example where the distance between the display panels is greater. The portions "V6" on the side surfaces of the display panels 2 and 4 may be unified with the panel housings 20 and 40 or may be a particular protective member. The thickness thereof is smaller than, equal to, or greater than that of the sidewalls of the panel housings 20 and 40.

The portions "V7" on the side surfaces of the optical members 27 and the input devices 200 and 400 may be unified with the panel housings 20 and 40 or may be a particular protective member. However, the thickness is smaller than that of the portions "V6".

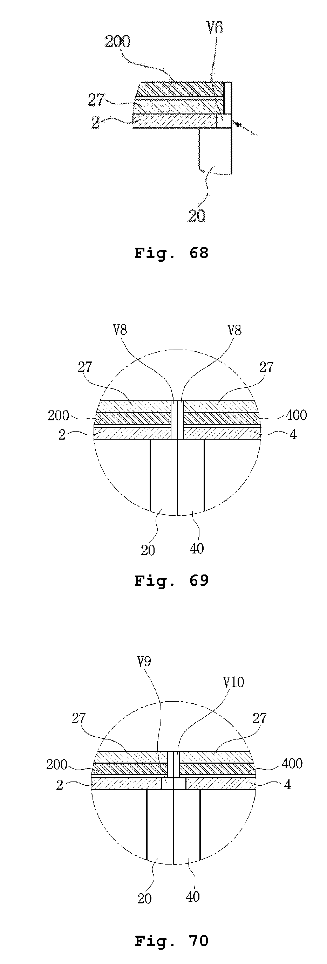

Fig. 68 is a diagram illustrating the portions "V6" or "V7". When the portions "V6" or "V7" are formed of a transparent protective film or member, the outer surface indicated by an arrow in the drawing may be colored. That is, a colored film may be attached to the outer surface (indicated by the arrow in the drawing) or the outer surface may be coated with a colored material. The same color as the panel housings may be selected.

Figs. 69 and 70 are diagrams illustrating an example where the optical members are disposed at the uppermost.

The portions "V8" are the same as the portions "V5" shown in Fig. 66, except that the optical member 27 are disposed on the input devices 200 and 400.

The portions "V9" and "V10" are the same as the portions "V7" and "V6" shown in Fig. 67, except that the optical members 27 and the input devices 200 and 400 are inverted.

In the examples shown in Figs. 66 to 70, the distance between the display panels 2 and 4, the distance between the optical members 27 and 27, and the distance between the input devices 200 and 400 are the same as described with reference to Figs. 25 to 31.

The optical members 27 used in the invention may include all types of members changing the optical path toward the joint, such as a micro lens, a micro prism, or a refractive lens.

In Figs. 66 to 70, the sidewalls of the panel housings constitute the joint. The same is true of the case where the lid sidewalls constitute the joint.

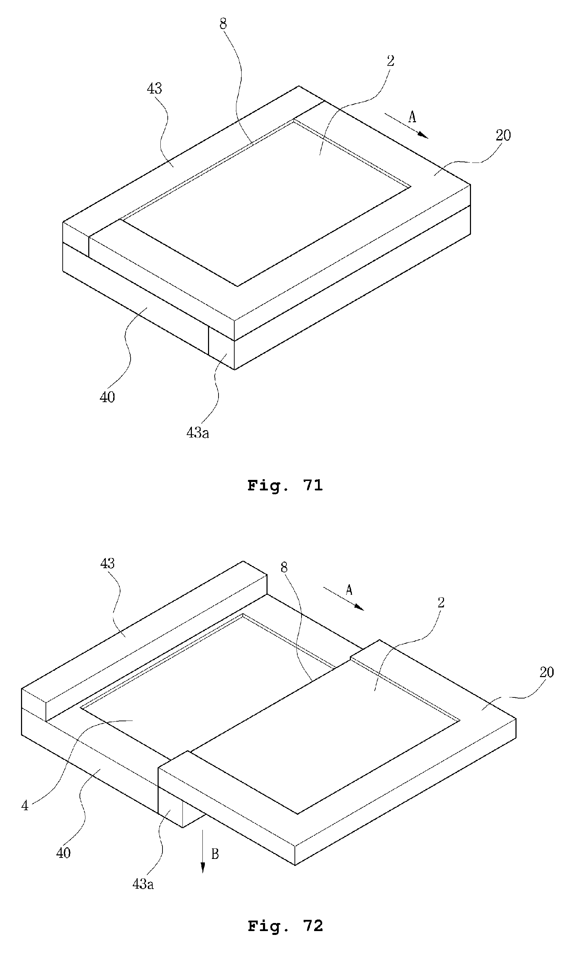

Figs. 71 to 76 show a sliding structure which is an example of the invention.

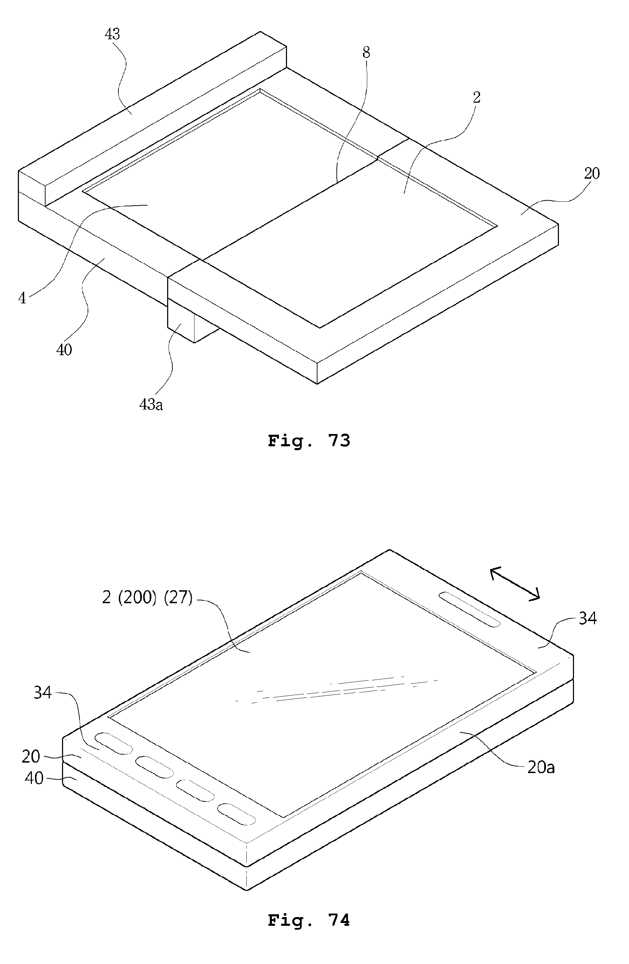

The panel housings 20 and 40 mounted with the display panels 2 and 4 are first stacked as shown in Fig. 71, are horizontally stretched into the state shown in Fig. 72, and then are vertically moved into the state shown in Fig. 73. Finally, the display panels 2 and 4 are continuous to each other.

The example shown in Figs. 71 to 73 can employ the ⊂-shaped lid 24 (see Figs. 37 and 39) or the ⊂-shaped printed mask 16d (see Fig. 40).

The example shown in Figs. 74 to 76 can employ the □-shaped or =-shaped lid 34 (see Figs. 50 to 53) or the □-shaped or =-shaped printed mask 16d (see Figs. 55 and 56).

The panel housings 20 and 40 are changed from the state (74) where two panel housings are stacked to the state (76) where two input devices are contiguous to each other via the state (75) where the panel housings are horizontally moved as indicated by the arrow.

The invention can be applied to the sliding type portable display device.

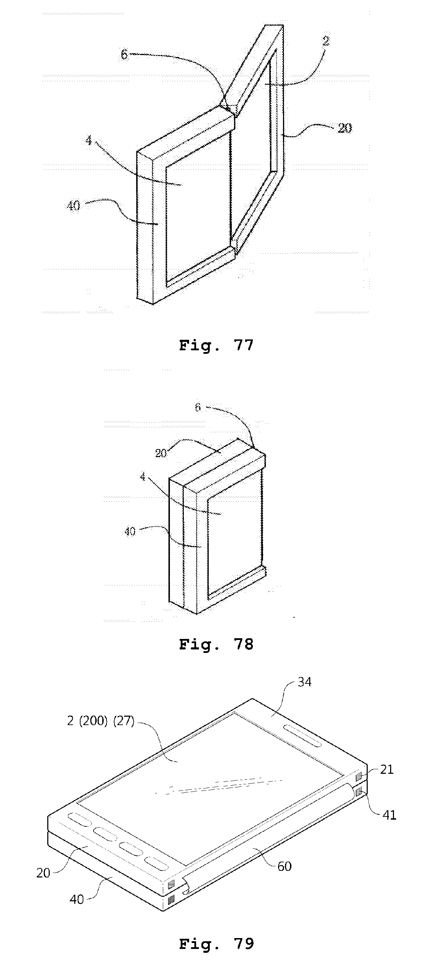

Figs. 77 to 82 are diagrams illustrating other examples of the invention.

As shown in the drawings, the panel housings 20 and 40 mounted with the display panels 2 and 4, respectively, are folded so that the display panels face the outside.

The example shown in Figs. 77 and 78 can employ the ⊂-shaped lid 24 (see Figs. 37 and 39) or the ⊂-shaped printed mask 16d (see Fig. 40). When the panel housings are folded as shown in Fig. 78, the display panels 2 and 4 face the outside of the portable display device.

The example shown in Figs. 79 to 82 can employ the □-shaped or =-shaped lid 34 (see Figs. 50 to 53) or the □-shaped or =-shaped printed mask 16d (see Figs. 55 and 56).

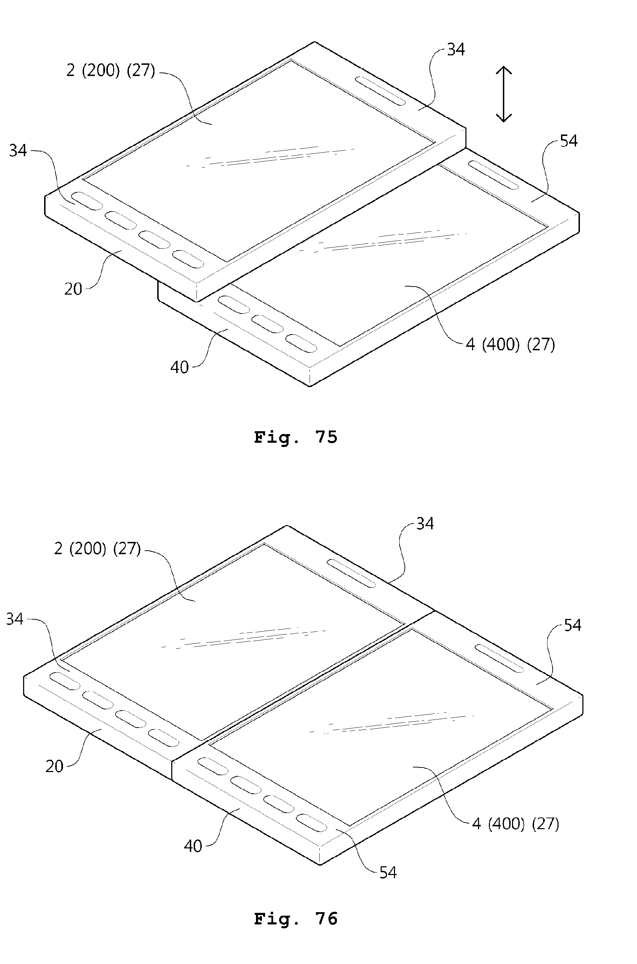

When the panel housings are completely unfolded, the panel housings are in the same state as shown in Fig. 76 via a partially-folded state (80) and a completely-folded state (79).

As shown in the drawings, coupling members 21 and 41 may be provided to fix the unfolded panel housings. The coupling members 21 and 41 may include magnets of N and S poles, or may include grooves and protrusions.

A joining member 60 covers two shafts coupled to the first panel housing 20 and the second panel housing. That is, the panel housings are folded and unfolded using two shafts. A single shaft may be employed as shown in Figs. 1 and 2.

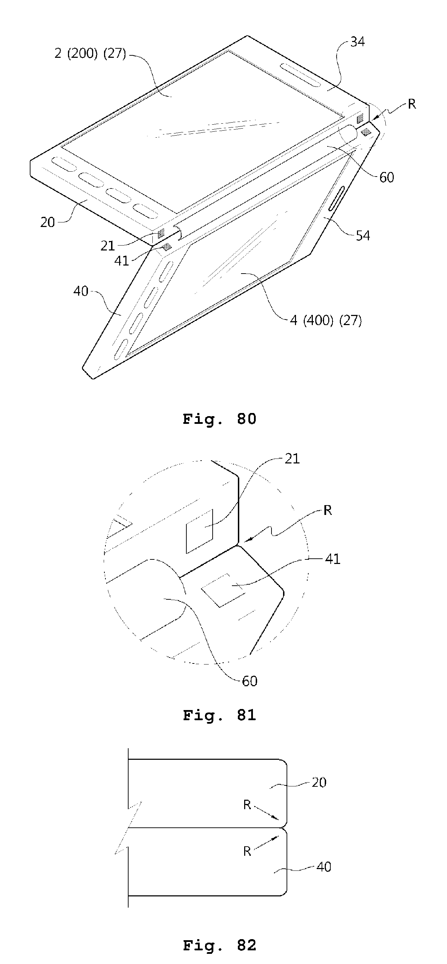

The portions at which the panel housings 20 and 40 come in contact with each other in the folding and unfolding may be rounded to smoothly perform the folding and unfolding, as shown in Figs. 81 and 82.

Fig. 82 is a side view of Fig. 79, where the contact corners of the panel housings are rounded.

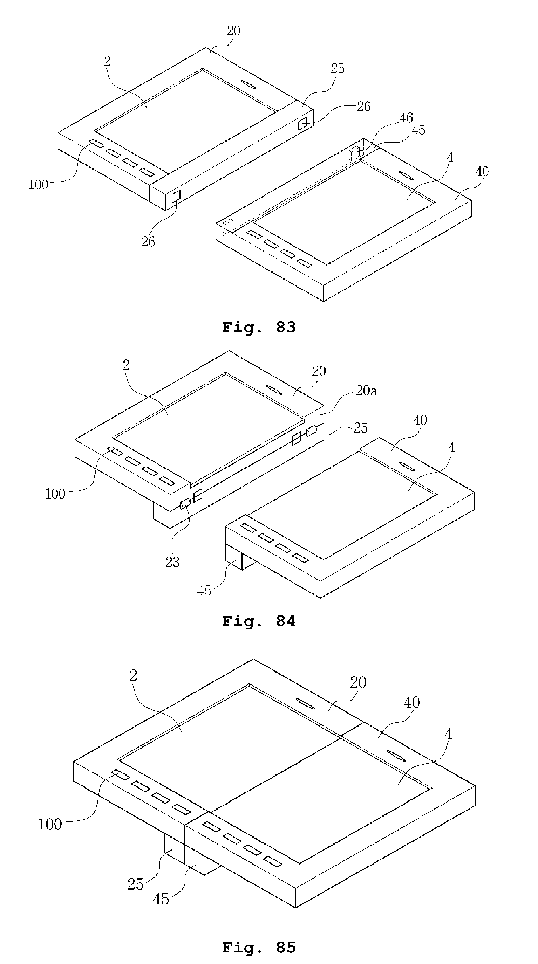

Figs. 83 to 87 show an example where the invention is applied to a coupling type display device.

The example shown in Figs. 83 to 86 can employ the ⊂-shaped lid 24 (see Figs. 37 and 39) or the ⊂-shaped printed mask 16d (see Fig. 40).

Fig. 83 shows a state where the panel housings 20 and 40 mounted with the display panels 2 and 4, coupling members 26 and 46, and lids 25 and 45 are decoupled from each other. The lids 25 and 45 coupled to the panel housings with shafts 23 can be opened (see Fig. 84). Then, the panel housings 20 and 40 can be coupled to each other and the display panels 2 and 4 are contiguous to each other (see Fig. 85).

The panel housings 20 and 40 may be coupled to each other so as to use two screens without opening the lids 25 and 45.

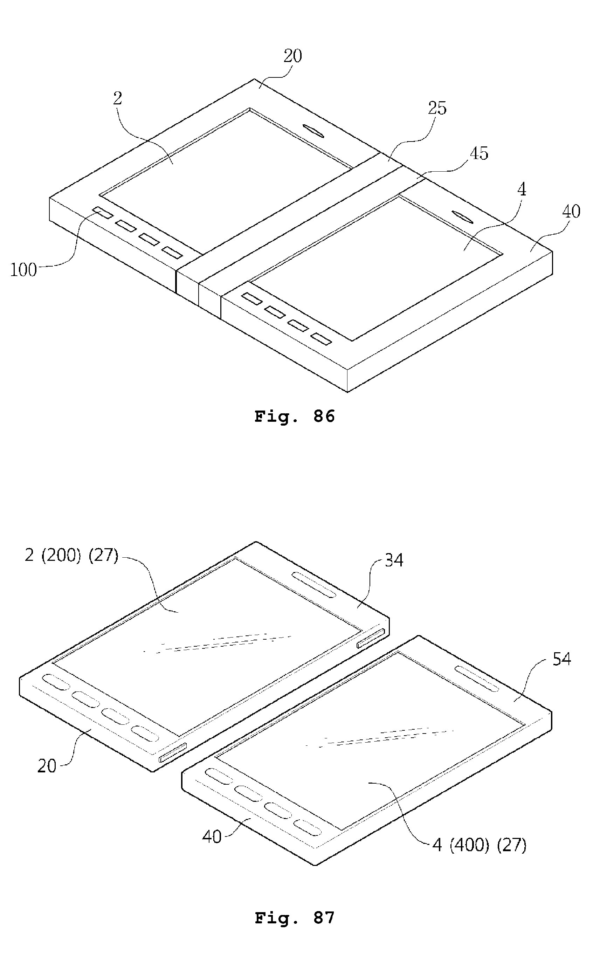

The example shown in Fig. 87 can employ the □-shaped or =-shaped lid 34 (see Figs. 50 to 53) or the □-shaped or =-shaped printed mask 16d (see Figs. 55 and 56).

Fig. 87 shows the decoupled state. As shown in the drawing, the coupling devices 21a are disposed to hold the strong coupling. The coupling devices include magnets or a groove and protrusion structure.

In the coupled state, the panel housings have a shape similar to that shown in Fig. 76.

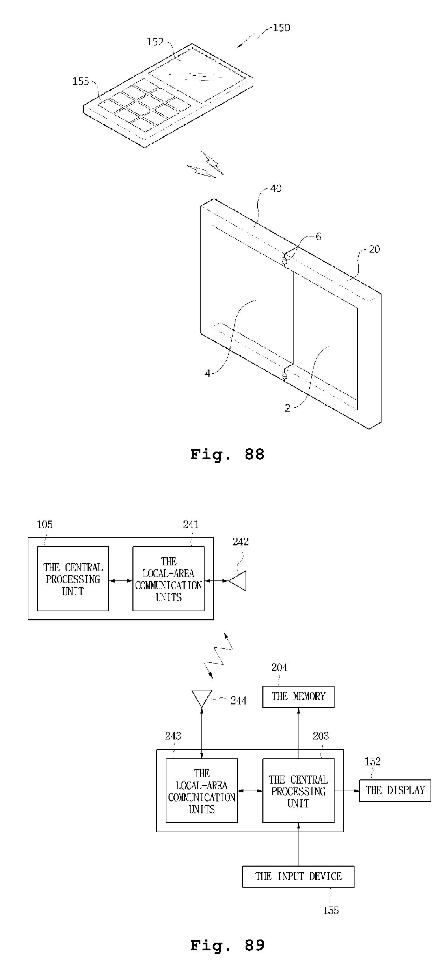

Figs. 88 to 90 are diagrams illustrating the configuration for controlling the portable display device according to the invention in a wired or wireless manner.

One goal of the invention is to utilize two screens so as to enhance the performance of the portable display device including the display panels. In some cases, the size of a single display panel may be 5 inches or more. The portable display device according to the invention may have a communication function like a mobile phone.

When the display panels have a large screen, the portable display device may further include a particular terminal 150 serving as a mobile phone. The terminal 150 includes an input unit 155 through which numerals or letters can be input and a display panel 152 displaying information.

Accordingly, all the details of the display device described above can be applied to the display device including two display panels shown in Fig. 88.

Fig. 89 is a diagram illustrating an example where a telecommunication module is disposed in the display device including two screens.

A central processing unit shown in the drawing further includes a local-area communication unit 241 and an antenna 242 in addition to the configuration shown in Fig. 10. The other components are not shown for the purpose of facilitating the explanation.

The local-area communication unit 241 can be unified with the central processing unit 105 to form a single module.

The terminal 150 includes a local-area communication unit 243 and an antenna 244 and may further include a RAM, a ROM, and an EEPROM 204. A particular central processing unit 203 used to control the memory 204, the display panel 152, and the input device 155 is provided.

Although not shown for the purpose of facilitating the explanation, a microphone and a speaker for voice communication may be further provided. As shown in the drawings, a touch type input device instead of the button type input device may be disposed on the display panel.

The telecommunication module may be a normal communication module used to transmit and receive information to and from a wide area network. The local-area communication unit 241 may be a communication module for communication with the terminal 150.

Examples of the local area network include all local-area communication devices such as Bluetooth, UWB (Ultra-Wide Band), Zigbee, Wibree, binary CDMA, infrared communication, and RS-232 port.

The central processing unit 203 and the local-area radio communication unit 243 of the terminal 150 may be formed in a module.

The information input through the input unit 155 of the terminal is transmitted to the central processing unit 200 via the local-area communication units 241 and 243 to perform a control corresponding to the input information. The information generated in the input unit, such as input of letters or numerals and start and end of a call, is transmitted to the central processing unit 105.

Information controlled by the central processing unit 105 is transmitted to the terminal and is output from the display panel 152 or the speaker of the terminal 105.

The local-area radio communication units 241 and 243 and the antennas 242 and 244 are used to transmit and receive such information.

At the time of transmitting information, the information is encoded, the encoded information is converted, and the converted information is sent via the antenna by a signal transmitting unit.

At the time of receiving information, the information received via the antenna is converted into a signal by a signal receiving unit and the signal is then decoded.

That is, the local-area radio communication units 241 and 243 include a signal transceiver, a signal converter, a signal decoder, and a signal encoder.

A signal distributor instead of the central processing unit 203 may be disposed in the terminal 150 so as to distribute and send the signal output from the radio communication unit 243 to the speaker or the display panel. That is, the central processing unit is not necessarily provided.

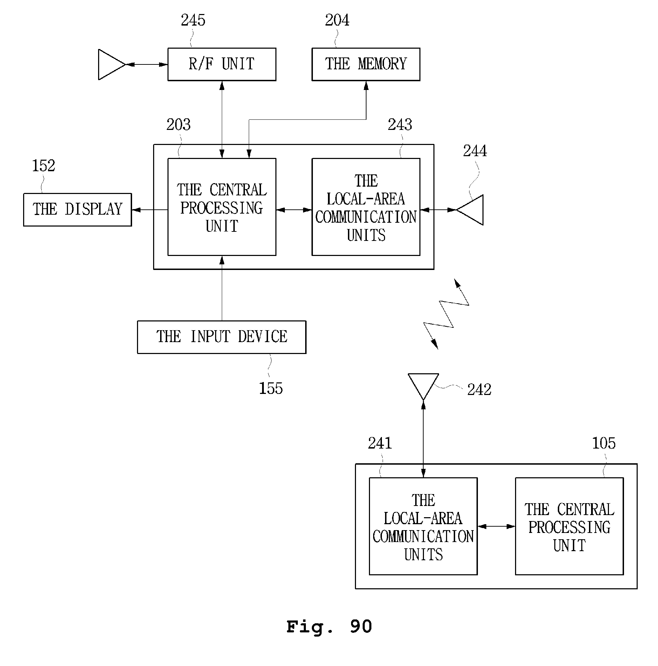

Fig. 90 is a diagram illustrating an example where a telecommunication module is disposed in the terminal.

The display device including two display panels 2 and 4 can be understood with reference to the block diagram shown in Fig. 10 and only the local-area communication unit is additionally shown.

A signal output from the telecommunication R/F unit 245 of the terminal 150 is transmitted to the central processing unit 203.

Among the information processed by the central processing unit 203 of the terminal 150, information to be displayed on the two display panels is transmitted to the large-screen display panels 2 and 4 via the local-area communication units 241 and 243.

Information input via the input unit 110 and the input devices 250-1 and 250-2 shown in Fig. 10 is transmitted to the central processing unit 203 of the terminal 150 via the local-area communication units 241 and 243.

The display device including two display panels 2 and 4 may serve as only a simple monitor. In this case, a signal distributor may be provided instead of the central processing unit 105 shown in Fig. 10. The information output from the local-area communication unit is transmitted to the corresponding display panel or the corresponding speaker.

The portable display device may not include the RAM, the ROM, and the EEPROM. In this case, the central processing unit 203 of the terminal 150 substantially controls two display panels 2 and 4 and two input devices 250-1 and 250-2. The RAM, the ROM, and the EEPROM of the terminal 150 perform high functions.

The input devices 2501- and 250-2 shown in the block diagram employ the input devices 200 and 400 shown in the drawings.

The display device including two display panels and the terminal may be connected to each other in a wired manner, instead of a wireless manner.

## Claims

1. A portable display device having at least two panel housings and first and second display panels mounted on the panel housings, respectively, in which the display panels are joined to each other to form a single screen when the panel housings are unfolded,
wherein the first and second display panels display a single picture vertically or horizontally divided into two parts,
wherein the first and second display panels are configured to be contiguous to each other,
wherein a first input unit corresponding to output information to the first display panel and a second input device corresponding to output information to the second display panel are provided, and
wherein the first and second input devices are contiguous to each other to serve as a single input device.

2. The portable display device according to claim 1, wherein a gravity sensor is disposed in each of the panel housings, and
wherein a central processing unit selects one of an operation of vertically dividing a picture to be displayed and an operation of horizontally dividing the picture depending on the output of the gravity sensors.

3. The portable display device according to claim 1, wherein the distance between the first and second display panels is in the range of 0.01 mm to 5 mm and the distance between the first and second input devices is in the range of 0.01 mm to 4 mm.

4. The portable display device according to claim 1, wherein optical members are disposed on the display panels, respectively, and
wherein the distance between the optical members is in the range of 0.01 mm to 3 mm.

5. The portable display device according to claim 1, wherein when a text line is located at a boundary between the first and second display panels, the screen is shifted so that the boundary between the first and second display panels is located in a space between the text lines.
